# EUROPEAN PATENT APPLICATION

(11) **EP 4 383 341 A2**
(43) Date of publication of application: **12.06.2024**
(21) Application number: 23192937.3
(22) Date of filing: 23.08.2023
(51) Int. Cl.: H01L 29/06, H01L 29/08, H01L 29/161, H01L 29/165, H01L 29/417, H01L 29/423, H01L 29/66, H01L 29/775, H01L 29/201, B82Y 10/00, H01L 29/78, H01L 27/088

(54) **NANOSHEET SEMICONDUCTOR DEVICE COMPRISING A MULTILAYER SOURCE/DRAIN REGION**

(30) Priority: 09.12.2022 KR 20220171654
(71) Applicant: Samsung Electronics Co., Ltd., Suwon-si, Gyeonggi-do 16677 (KR)
(72) Inventor: SHIN, Dong Suk, 16677 Suwon-si, Gyeonggi-do (KR); KIM, Jung Taek, 16677 Suwon-si, Gyeonggi-do (KR); YU, Hyun-Kwan, 16677 Suwon-si, Gyeonggi-do (KR); KIM, Seok Hoon, 16677 Suwon-si, Gyeonggi-do (KR); PARK, Pan Kwi, 16677 Suwon-si, Gyeonggi-do (KR); JEONG, Seo Jin, 16677 Suwon-si, Gyeonggi-do (KR); CHO, Nam Kyu, 16677 Suwon-si, Gyeonggi-do (KR)
(74) Representative: Kuhnen & Wacker Patent- und Rechtsanwaltsbüro PartG mbB

(57) **Abstract**

There is provided a semiconductor device, preferably a nanosheet field-effect transistor, capable of improving performance and reliability of an element. The semiconductor device includes an active pattern (NS1) extending in a first direction, (D1) and a plurality of gate structures (INT_GS1) spaced apart from each other in the first direction on the active pattern. Each gate structure comprises a gate electrode (120) extending in a second direction and a gate spacer (GS1, 140) on a sidewall of the gate electrode and a source/drain pattern (150, 151, 152) disposed between adjacent gate structures. The source/drain structure comprises a semiconductor liner layer (151) and a semiconductor filling layer (152) on the semiconductor liner layer, wherein the semiconductor liner layer and the semiconductor filling layer are formed of silicon-germanium. The semiconductor filling layer comprises an upper portion (152UP) protruding in a third direction beyond an upper surface of the active pattern (NS1). A maximum width of the upper portion of the semiconductor filling layer in the first direction is greater than a width of the semiconductor filling layer in the first direction at the vertical position of the upper surface of the active pattern (NS1). Furthermore, in a plan view (Fig. 5), the inner surface of the semiconductor liner layer comprises a concave region.

## Description

### CROSS-REFERENCE TO RELATED APPLICATION

This application claims priority from Korean Patent Application No. 10-2022-0171654 filed on December 09, 2022 in the Korean Intellectual Property Office, and all the benefits accruing therefrom under 35 U.S.C. 119, the contents of which in its entirety are herein incorporated by reference.

### BACKGROUND

### Technical Field

The present disclosure relates to a semiconductor device.

### Description of the Related Art

A multi-gate transistor, in which a fin- or nanowire-shaped multi-channel active pattern (or silicon body) is formed on a substrate and a gate is formed on the surface of the multi-channel active pattern, is a technique for increasing the density of semiconductor devices.

Since the multi-gate transistor uses a three-dimensional (3D) channel, scaling of the multi-gate transistor can be facilitated. One issue is improvement of current control capability without increasing the gate length of the multi-gate transistor. Another issue is short channel effect (SCE), in which the potential of a channel region is affected by a drain voltage.

### SUMMARY

Aspects of the present disclosure provide a semiconductor device capable of improving element performance and reliability.

However, aspects of the present disclosure are not restricted to the embodiments set forth herein. The above and other aspects of the present disclosure will become more apparent to one of ordinary skill in the art to which the present disclosure pertains by referencing the detailed description of the present disclosure given below.

According to aspects of the present disclosure, there is provided a semiconductor device comprising an active pattern extending in a first direction, a plurality of gate structures spaced apart from each other in the first direction on the active pattern, each comprising a gate electrode extending in a second direction and a gate spacer on a sidewall of the gate electrode, and a source/drain pattern disposed between adjacent gate structures. The source/drain pattern comprises a semiconductor liner layer and a semiconductor filling layer on the semiconductor liner layer. The semiconductor liner layer and the semiconductor filling layer include silicon-germanium. The semiconductor filling layer comprises an upper portion protruding in a third direction beyond an upper surface of the active pattern. A maximum width of the upper portion of the semiconductor filling layer in the first direction is greater than a width of the semiconductor filling layer in the first direction on the upper surface of the active pattern. The semiconductor liner layer comprises an outer surface in contact with the active pattern and an inner surface facing the semiconductor filling layer. In a plan view, the inner surface of the semiconductor liner layer comprises a concave region.

According to aspects of the present disclosure, there is provided a semiconductor device comprising an active pattern extending in a first direction, a plurality of gate structures spaced apart from each other in the first direction on the active pattern, each comprising a gate electrode extending in a second direction and a gate spacer on a sidewall of the gate electrode, and a source/drain pattern disposed between adjacent gate structures. The source/drain pattern comprises a semiconductor liner layer and a semiconductor filling layer on the semiconductor liner layer. The semiconductor liner layer and the semiconductor filling layer include silicon-germanium. The gate spacer comprises an extension portion extending in the second direction along a sidewall of the gate electrode, and a protrusion portion protruding from the extension portion of the gate spacer in the first direction. The gate spacer comprises an inner wall facing the gate electrode and extending in the second direction, and a connection sidewall connected to the inner wall of the gate spacer and extending in the first direction. The semiconductor liner layer comprises an outer surface in contact with the active pattern and an inner surface facing the semiconductor filling layer. In a plan view, an inner surface of the semiconductor liner layer comprises a separation point located farthest from the inner wall of the gate spacer in the first direction. A distance between the separation point and the inner wall of the gate spacer in the first direction is greater than a distance between a terminal end of the protrusion portion of the first spacer and the inner wall of the gate spacer in the first direction, and the inner surface of the semiconductor liner layer comprises a concave region.

According to aspects of the present disclosure, there is provided a semiconductor device comprising an active pattern extending in a first direction, a plurality of gate structures spaced apart from each other in the first direction on the active pattern, each comprising a gate electrode extending in a second direction and a gate spacer on a sidewall of the gate electrode, and a source/drain pattern disposed between adjacent gate structures and comprising a semiconductor liner layer and a semiconductor filling layer on the semiconductor liner layer. A source/drain etching stop layer is disposed on the source/drain pattern and extends along a sidewall of the gate spacer. The semiconductor liner layer and the semiconductor filling layer include silicon-germanium. The gate spacer comprises a first spacer and a second spacer. The second spacer is disposed between the first spacer and the source/drain etching stop layer and extends along the sidewall of the gate electrode and an upper surface of the source/drain pattern. A thickness of the second spacer along the sidewall of the gate electrode is greater than or equal to a thickness of the second spacer along the upper surface of the source/drain pattern. The semiconductor liner layer comprises an outer surface in contact with the active pattern and an inner surface facing the semiconductor filling layer. In a plan view, the inner surface of the semiconductor liner layer comprises a concave region.

It should be noted that the effects of the present invention are not limited to those described above, and other effects of the present invention will be apparent from the following description.

### BRIEF DESCRIPTION OF THE DRAWINGS

The above and other aspects and features of the present disclosure will become more apparent by describing in detail illustrative embodiments thereof with reference to the attached drawings, in which:
FIG. 1 is an example plan view illustrating a semiconductor device according to some embodiments.
FIGS. 2 and 3 are cross-sectional views taken along lines A-A and B-B of FIG. 1.
FIG. 4 is a diagram illustrating the shape of the first sheet pattern of FIG. 2.
FIG. 5 is a top plan view taken along line C-C of FIG. 2.
FIG. 6 is a top plan view taken along line D-D of FIG. 2.
FIGS. 7 and 8 are enlarged views of two examples of part P of FIG. 2.
FIGS. 9 to 11 are enlarged views of three embodiments of part Q of FIG. 2.
FIGS. 12 to 37 are cross-sectional and plan view diagrams illustrating aspects of semiconductor devices according to some embodiments.
FIGS. 38 to 54 are diagrams illustrating the intermediate steps of a method for fabricating a semiconductor device according to some embodiments.

### DETAILED DESCRIPTION OF THE EMBODIMENTS

Ordinal numbers such as "first," "second," "third," etc. may be used simply as labels of certain elements, steps, etc., to distinguish such elements, steps, etc. from one another. Terms that are not described using "first," "second," etc., in the specification, may still be referred to as "first" or "second" in a claim. In addition, a term that is referenced with a particular ordinal number (e.g., "first" in a particular claim) may be described elsewhere with a different ordinal number (e.g., "second" in the specification or another claim).

In the drawings of the semiconductor device according to some embodiments, for example, a fin-shaped transistor (FinFET) including a channel region of a fin-shaped pattern, a transistor including a nanowire or a nanosheet, or a multi-bridge channel field effect transistor (MBCFET^{™}) is illustrated, but is not limited thereto.

The semiconductor device according to some embodiments may include a tunneling FET or a three-dimensional (3D) transistor. The semiconductor device according to some embodiments may include transistors based on two-dimensional materials (2D material-based FETs) and heterostructures thereof. The semiconductor device according to some embodiments may include a bipolar junction transistor, a lateral double diffusion MOS (LDMOS) transistor, or the like.

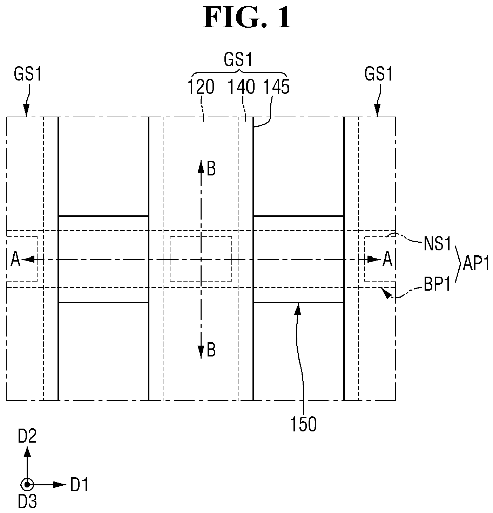

A semiconductor device according to some embodiments will be described with reference to FIGS. 1 to 11.

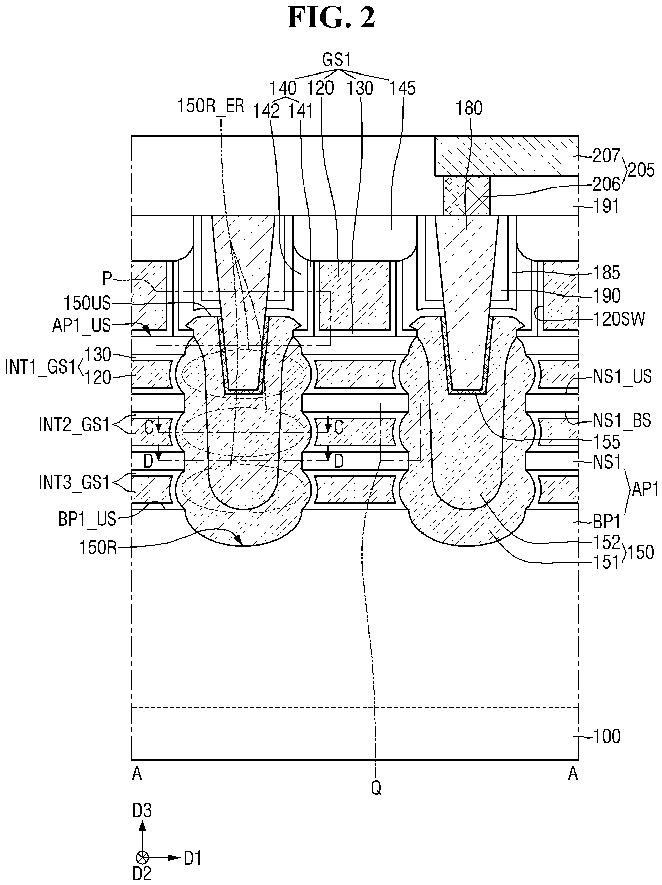

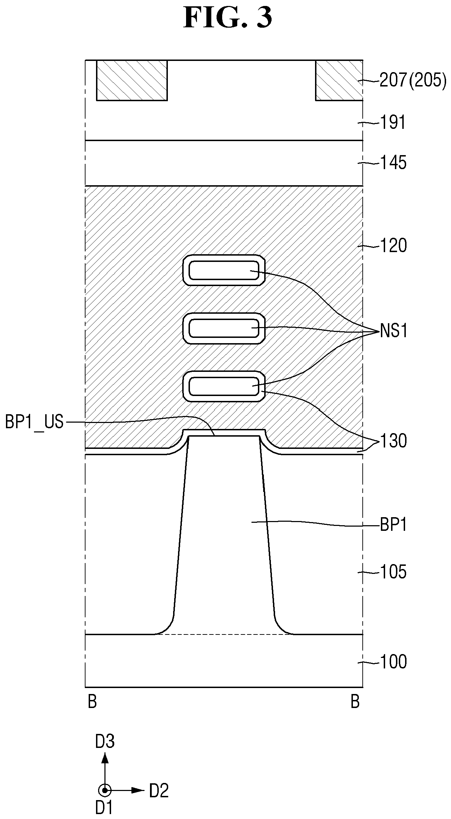

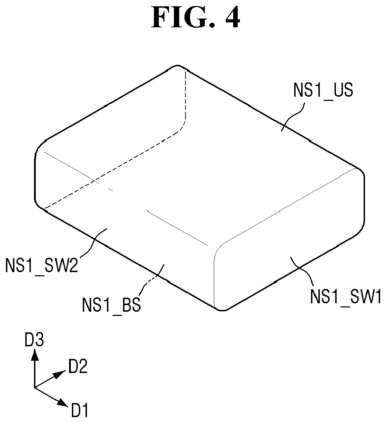

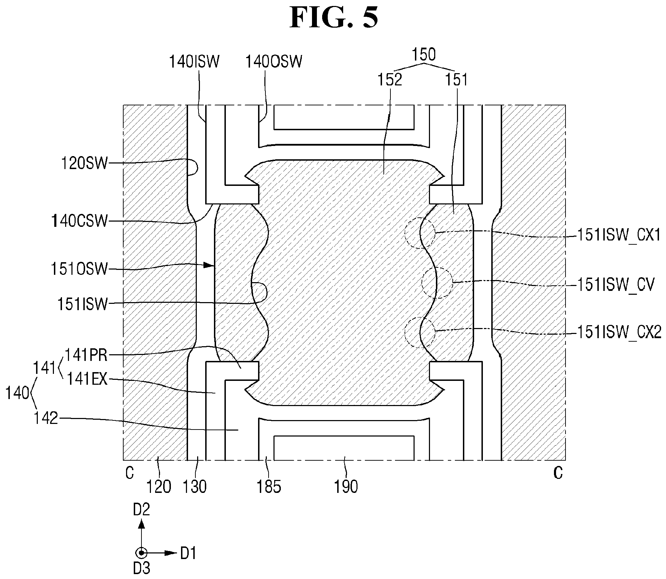

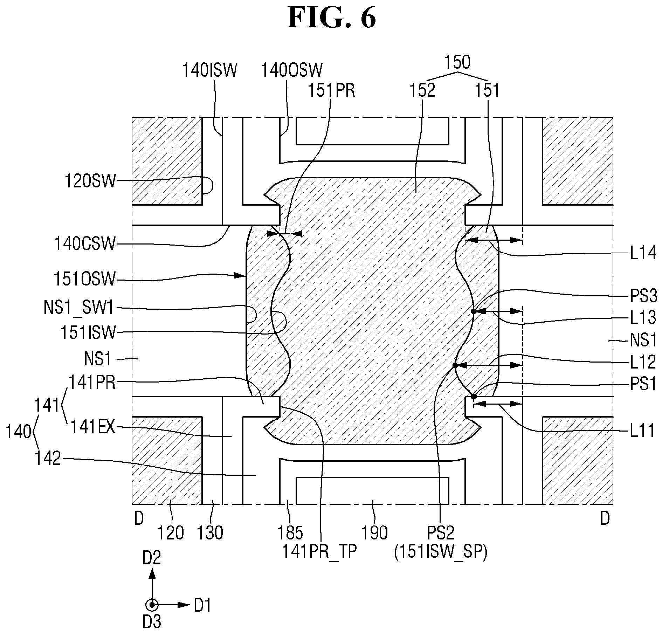

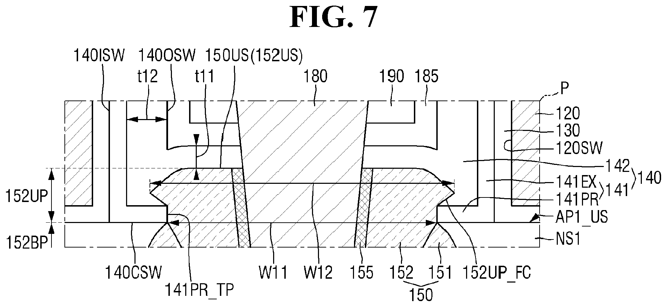

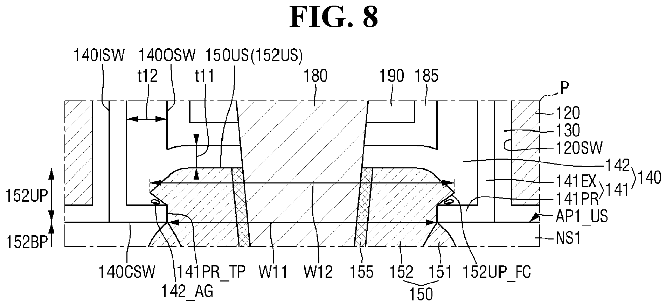

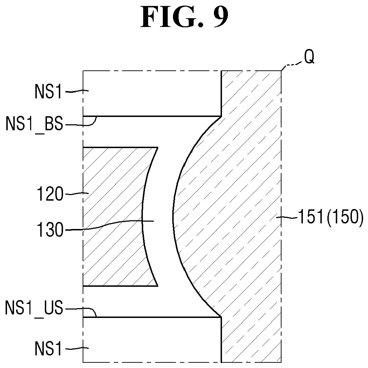

FIG. 1 is an example plan view illustrating a semiconductor device according to some embodiments. FIGS. 2 and 3 are cross-sectional views taken along lines A-A and B-B of FIG. 1. FIG. 4 is a diagram illustrating the shape of the first sheet pattern of FIG. 2. FIG. 5 is a top plan view taken along line C-C of FIG. 2. FIG. 6 is a top plan view taken along line D-D of FIG. 2. FIGS. 7 and 8 are enlarged views of exemplary structures of part P of FIG. 2. FIGS. 9 to 11 are enlarged views of exemplary structures of part Q of FIG. 2.

For reference, FIGS. 1 to 11 illustrate a schematic configuration including a first gate insulating layer 130, a source/drain etching stop layer 185, interlayer insulating layers 190 and 191, a wiring structure 205, and the like.

Referring to FIGS. 1 to 11, the semiconductor device according to some embodiments may include a first active pattern AP1, a plurality of first gate structures GS1, and a first source/drain pattern 150.

The substrate 100 may be a bulk silicon or silicon-on-insulator (SOI) substrate. Alternatively, the substrate 100 may be another type of silicon substrate, and may include other materials such as silicon germanium, silicon germanium on insulator (SGOI), indium antimonide, a lead tellurium compound, indium arsenide, indium phosphide, gallium arsenide, or gallium antimonide, but is not limited thereto.

The first active pattern AP1 may be disposed on the substrate 100. The first active pattern AP1 may be elongated in a first direction D1. For example, the first active pattern AP1 may be disposed in a region where a PMOS transistor is formed. As another example, the first active pattern AP1 may be disposed in a region where an NMOS transistor is formed. In the following description, a case in which the first active pattern AP1 is disposed in the region where the PMOS transistor is formed will be described.

The first active pattern AP1 may be a multi-channel active pattern. The first active pattern AP1 may include a first lower pattern BP1 and a plurality of first sheet patterns NS 1.. The first lower pattern BP1 may protrude from the substrate 100. The first lower pattern BP1 may be elongated in a first direction D1.

The plurality of first sheet patterns NS1 may be disposed on an upper surface BP1_US of the first lower pattern. The plurality of first sheet patterns NS1 may be spaced apart from the first lower pattern BP1 in the third direction D3. The first sheet patterns NS1 may be spaced apart from each other in the third direction D3.

Each first sheet pattern NS1 may include an upper surface NS1_US and a bottom surface NS1_BS. The upper surface NS1_US of the first sheet pattern is opposite to the bottom surface NS1_BS of the first sheet pattern in the third direction D3. Each first sheet pattern NS1 may include first sidewalls NS1_SW1 facing in the first direction D1 and second sidewalls NS1_SW2 facing in a second direction D2. The third direction D3 may intersect the first direction D1 and the second direction D2. For example, the third direction D3 may be a thickness direction of the substrate 100. The first direction D1 may be a direction crossing the second direction D2.

The upper surface NS1_US of the first sheet pattern and the bottom surface NS1_BS of the first sheet pattern may be connected by the first sidewalls NS1_SW1 of the first sheet pattern and the second sidewalls NS1_SW2 of the first sheet pattern. The first sidewalls NS1_SW1 of the first sheet pattern are connected to and in contact with the first source/drain pattern 150 to be described later. The first sidewalls NS1_SW1 of the first sheet pattern may include the terminal end of the first sheet pattern NS 1. For example, the terminal end of the first sheet pattern NS 1 may be located on the central line between the upper surface NS1_US of the first sheet pattern and the bottom surface NS1_BS of the first sheet pattern, but the present invention is not limited thereto. It will be understood that when an element is referred to as being "connected" or "coupled" to or "on" another element, it can be directly connected or coupled to or on the other element or intervening elements may be present. In contrast, when an element is referred to as being "directly connected" or "directly coupled" to another element, or as "contacting" or "in contact with" another element (or using any form of the word "contact"), there are no intervening elements present at the point of contact.

An upper surface AP1_US of the first active pattern may be the upper surface of the uppermost first sheet pattern among the plurality of first sheet patterns NS1. Although it is illustrated that three first sheet patterns NS1 are arranged in the third direction D3, this is merely for simplicity of description and the present invention is not limited thereto.

The first lower pattern BP1 may be a portion of substrate 100 and may be formed by etching a part of the substrate 100, or may be an epitaxial layer grown from the substrate 100. The first lower pattern BP1 may be formed of a semiconductor material, such as crystalline silicon or germanium, each of which is an elemental semiconductor material. Alternatively, the first lower pattern BP1 may be formed of a compound semiconductor (which may have crystalline form), for example, a group IV-IV compound semiconductor or a group III-V compound semiconductor.

The group IV-IV compound semiconductor may be a binary compound or a ternary compound including at least two elements selected from the group consisting of carbon (C), silicon (Si), germanium (Ge) and tin (Sn), or the above-mentioned compound doped with a group IV element.

The group III-V compound semiconductor may be, for example, a binary compound, a ternary compound or a quaternary compound formed by combining at least one of aluminum (Al), gallium (Ga) and indium (In) which are group III elements with one of phosphorus (P), arsenic (As) and antimonium (Sb) which are group V elements.

The first sheet pattern NS1 may be a crystalline semiconductor material, such as silicon or germanium, which is an elemental semiconductor material, a group IV-IV compound semiconductor, or a group III-V compound semiconductor. Each of the first sheet patterns NS1 may be formed of the same material as the first lower pattern BP1, or may include a material different from that of the first lower pattern BP1.

In the semiconductor device according to some embodiments, the first lower pattern BP1 and the first sheet pattern NS1 may formed of silicon.

The width of the first sheet pattern NS1 in the second direction D2 may increase or decrease in proportion to the width of the first lower pattern BP1 in the second direction D2. In one example, although it is illustrated that the widths in the second direction D2 of the first sheet patterns NS1 stacked in the third direction D3 are the same, this is merely for simplicity of description, and the present invention is not limited thereto. Unlike the illustrated example, the width in the second direction D2 of the first sheet patterns NS1 stacked in the third direction D3 may decrease as the distance from the first lower pattern BP1 increases.

A field insulating layer 105 may be formed on the substrate 100. The field insulating layer 105 may be disposed on the sidewall of the first lower pattern BP1. The field insulating layer 105 is not disposed on the upper surface BP1_US of the first lower pattern.

For example, the field insulating layer 105 may cover the entire sidewall of the first lower pattern BP1. Unlike the illustrated example, the field insulating layer 105 may cover only a part of the sidewall of the first lower pattern BP1. In this case, a part of the first lower pattern BP1 may protrude from the upper surface of the field insulating layer 105 in the third direction D3.

Each first sheet pattern NS1 is disposed higher than the upper surface of the field insulating layer 105. The field insulating layer 105 may be formed of, for example, an oxide layer, a nitride layer, an oxynitride layer, or a combination layer thereof. In other words, although the field insulating layer 105 is illustrated as being a single layer, this is only for simplicity of description, and the present invention is not limited thereto.

A plurality of first gate structures GS1 may be disposed on the substrate 100. Each of the first gate structures GS1 may extend in the second direction D2. The first gate structures GS1 may be spaced apart from each other in the first direction D1. The first gate structures GS1 may be adjacent to each other in the first direction D1. For example, the first gate structures GS 1 may be disposed on both sides of the first source/drain pattern 150 in the first direction D1.

The first gate structure GS 1 may be disposed on the first active pattern AP1. The first gate structure GS1 may cross the first active pattern AP1. The first gate structure GS1 may cross the first lower pattern BP1. The first gate structure GS1 may surround each of the first sheet patterns NS1. The first gate structure GS1 may include, for example, the first gate electrode 120, a first gate insulating layer 130, a first gate spacer 140, and a first gate capping pattern 145.

The first gate structure GS 1 may include a plurality of inner gate structures INT1_GS1, INT2_GS1, and INT3_GS1 disposed between the first sheet patterns NS1 adjacent in the third direction D3, and between the first lower pattern BP1 and the first sheet pattern NS1. The inner gate structures INT1_GS1, INT2_GS1, and INT3_GS1 may be disposed between the upper surface BP1_US of the first lower pattern and the bottom surface NS1_BS of the first lowermost sheet pattern, and between the upper surface NS1_US of the first sheet pattern and the bottom surface NS1_BS of the first sheet pattern facing in the third direction D3. For example, the number of inner gate structures INT1_GS1, INT2_GS1, and INT3_GS1 may be the same as the number of first sheet patterns NS1.

The inner gate structures INT1_GS1, INT2_GS1, and INT3_GS1 are in contact with the upper surface BP1_US of the first lower pattern, the upper surface NS1_US of the first sheet pattern, and the bottom surface NS1_BS of the first sheet pattern. The inner gate structures INT1_GS1, INT2_GS1, and INT3_GS1 may be in contact with the first source/drain pattern 150 to be described later.

The first gate structure GS 1 may include the first inner gate structure INT1_GS1, the second inner gate structure INT2_GS1, and the third inner gate structure INT3_GS_1. The first inner gate structure INT1_GS1, the second inner gate structure INT2_GS1, and the third inner gate structure INT3_GS1 may be sequentially disposed on the first lower pattern BP1.

The third inner gate structure INT3_GS1 may be disposed between the first lower pattern BP1 and the first sheet pattern NS1. The third inner gate structure INT3_GS1 may be disposed at the lowermost part among the inner gate structures INT1_GS1, INT2_GS1, and INT3_GS1. The third inner gate structure INT3_GS1 may be the lowermost inner gate structure.

The first inner gate structure INT1_GS1 and the second inner gate structure INT2_GS1 may be disposed between the first sheet patterns NS1 adjacent in the third direction D3. The first inner gate structure INT1_GS1 may be disposed at the uppermost part among the inner gate structures INT1_GS1, INT2_GS1, and INT3_GS1. The first inner gate structure INT1_GS1 may be the uppermost inner gate structure. The second inner gate structure INT2_GS1 is disposed between the first inner gate structure INT1_GS1 and the third inner gate structure INT3_GS1.

The inner gate structures INT1_GS1, INT2_GS1, and INT3_GS1 include the first gate electrode 120 and the gate insulating layer 130 disposed between the adjacent first sheet patterns NS1, and between the first lower pattern BP1 and the first sheet pattern NS1.

For example, the width of the first inner gate structure INT1_GS1 in the first direction D1 may be the same as the width of the second inner gate structure INT2_GS1 in the first direction D1. The width of the third inner gate structure INT3_GS1 in the first direction D1 may be the same as the width of the second inner gate structure INT2_GS1 in the first direction D1.

As another example, the width of the third inner gate structure INT3_GS1 in the first direction D1 may be greater than the width of the second inner gate structure INT2_GS1 in the first direction D1. The width of the first inner gate structure INT1_GS1 in the first direction D1 may be the same as the width of the second inner gate structure INT2_GS1 in the first direction D1.

In the case of the second inner gate structure INT2_GS1, for example, the width of the second inner gate structure INT2_GS1 may be measured at an intermediate portion between the upper surface NS1_US of the first sheet pattern and the bottom surface NS1_BS of the first sheet pattern facing each other in the third direction D3.

For reference, the plan view at the level of the second inner gate structure INT2_GS1 is shown in FIG. 5. The plan view at the level of the first lowermost sheet pattern NS1 closest to the first lower pattern BP1 among the first sheet patterns NS1 is shown in FIG. 6. Although not shown, when the portion where a first contact 180 is formed is excluded, the plan view at the level of the other inner gate structures INT1_GS1 and INT3_GS1 may be similar to that of FIG. 5. Although not shown, when the portion where the first source/drain contact 180 is formed is excluded, the plan view at the level of another first sheet pattern NS1 may be similar to that of FIG. 6.

The first gate electrode 120 may be disposed on the first lower pattern BP1. The first gate electrode 120 may cross the first lower pattern BP1. The first gate electrode 120 may surround the first sheet pattern NS1. A part of the first gate electrode 120 may be disposed between the adjacent first sheet patterns NS1, and between the first lower pattern BP1 and the first sheet pattern NS1.

The first gate electrode 120 may be formed of at least one of a metal, a metal alloy, a conductive metal nitride, a metal silicide, a doped semiconductor material, a conductive metal oxide, or a conductive metal oxynitride. The first gate electrode 120 may be formed of, for example, at least one material selected from the group consisting of titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAlN), tantalum aluminum nitride (TaAlN), tungsten nitride (WN), ruthenium (Ru), titanium aluminum (TiAl), titanium aluminum carbonitride (TiAlC-N), titanium aluminum carbide (TiAlC), titanium carbide (TiC), tantalum carbonitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V) and a combination thereof. The conductive metal oxide and the conductive metal oxynitride may have a form in which the above-mentioned material is oxidized, but the invention is not limited thereto.

The first gate electrode 120 may be disposed on both sides of a first source/drain pattern 150, as further described below. The first gate structures GS1 may be disposed on both sides of the first source/drain pattern 150 in the first direction D1.

For example, the first gate electrode 120 disposed on both sides of the first source/drain pattern 150 may be used as gates of transistors. As another example, the first gate electrode 120 disposed on one side of the first source/drain pattern 150 may be used as a gate of a transistor, whereas the first gate electrode 120 disposed on the other side of the first source/drain pattern 150 may be a dummy gate electrode.

The first gate insulating layer 130 may extend along the upper surface of the field insulating layer 105 and the upper surface BP1_US of the first lower pattern. The first gate insulating layer 130 may surround the plurality of first sheet patterns NS1. The first gate insulating layer 130 may be disposed along the perimeter of the first sheet pattern NS1. The first gate electrode 120 is disposed on the first gate insulating layer 130. The first gate insulating layer 130 is disposed between the first gate electrode 120 and the first sheet pattern NS1. A part of the first gate insulating layer 130 may be disposed between the first sheet patterns NS1 adjacent in the third direction D3, and between the first lower pattern BP1 and the first sheet pattern NS1.

The first gate insulating layer 130 may be formed of silicon oxide, silicon-germanium oxide, germanium oxide, silicon oxynitride, silicon nitride, or a high-k material having a dielectric constant greater than that of silicon oxide. The high-k material may be, for example, at least one material selected from the group consisting of boron nitride, hafnium oxide, hafnium silicon oxide, hafnium aluminum oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate.

Although it is illustrated that the first gate insulating layer 130 is a single layer, it is merely for simplicity of description and the present invention is not limited thereto. The first gate insulating layer 130 may be formed of a plurality of layers. The first gate insulating layer 130 may include an interfacial layer and a high-k insulating layer disposed between the first sheet pattern NS1 and the first gate electrode 120.

The semiconductor device according to some embodiments may include a negative capacitor (NC) FET having a negative capacitor (NC). For example, the first gate insulating layer 130 may include a ferroelectric material layer having ferroelectric properties and a paraelectric material layer having paraelectric properties.

The ferroelectric material layer may have a negative capacitance, and the paraelectric material layer may have a positive capacitance. For example, when two or more capacitors are connected in series and the capacitance of each capacitor has a positive value, the total capacitance becomes smaller than the capacitance of each capacitor when at least one of these capacitors has a negative capacitance (and may be considered a negative capacitor). On the other hand, when at least one of the capacitances of two or more capacitors connected in series has a negative value, the total capacitance may have a positive value and may be greater than the absolute value of each capacitance.

When a ferroelectric material layer having a negative capacitance and a paraelectric material layer having a positive capacitance are connected in series, the total capacitance value of the ferroelectric material layer and the paraelectric material layer connected in series may increase. By using the principle that the total capacitance value is increased, the transistor containing the ferroelectric material layer may have a subthreshold swing (SS) lower than or equal to a threshold voltage lower than 60 mV/decade at room temperature.

The ferroelectric material layer may include various materials, for example, at least one of hafnium oxide, hafnium zirconium oxide, barium strontium titanium oxide, barium titanium oxide, or lead zirconium titanium oxide. In this case, as one example, the hafnium zirconium oxide may be a material containing hafnium oxide doped with zirconium (Zr). As another example, the hafnium zirconium oxide may be a compound of hafnium (Hf), zirconium (Zr), and oxygen (O).

The ferroelectric material layer may further include a dopant doped therein. For example, the dopant may be at least one of aluminum (Al), titanium (Ti), niobium (Nb), lanthanum (La), yttrium (Y), magnesium (Mg), silicon (Si), calcium (Ca), cerium (Ce), dysprosium (Dy), erbium (Er), gadolinium (Gd), germanium (Ge), scandium (Sc), strontium (Sr), or tin (Sn). The type of dopant included in the ferroelectric material layer may vary depending on which ferroelectric material is included in the ferroelectric material layer.

When the ferroelectric material layer includes hafnium oxide, the dopant included in the ferroelectric material layer may be, for example, at least one of gadolinium (Gd), silicon (Si), zirconium (Zr), aluminum (Al), or yttrium (Y).

When the dopant is aluminum (Al), the ferroelectric material layer may include 3 to 8 atomic percent (at%) of aluminum. In this case, the ratio of the dopant may be a ratio of aluminum to the sum of hafnium and aluminum.

When the dopant is silicon (Si), the ferroelectric material layer may include 2 to 10 at% of silicon. When the dopant is yttrium (Y), the ferroelectric material layer may include 2 to 10 at% of yttrium. When the dopant is gadolinium (Gd), the ferroelectric material layer may include 1 to 7 at% of gadolinium. When the dopant is zirconium (Zr), the ferroelectric material layer may include 50 to 80 at% of zirconium.

The paraelectric material layer may include various materials, for example, at least one of silicon oxide or metal oxide having a high dielectric constant. The metal oxide included in the paraelectric material layer may include, for example, at least one of hafnium oxide, zirconium oxide, or aluminum oxide, but is not limited thereto.

The ferroelectric material layer and the paraelectric material layer may be formed of the same material. The ferroelectric material layer may have ferroelectric properties, but the paraelectric material layer may not have ferroelectric properties. For example, when the ferroelectric material layer and the paraelectric material layer include hafnium oxide, the crystal structure of the hafnium oxide included in the ferroelectric material layer may be different from the crystal structure of the hafnium oxide included in the paraelectric material layer.

The ferroelectric material layer may exhibit ferroelectric properties based on its thickness. The thickness of the ferroelectric material layer may be, for example, in a range of 0.5 nm to 10 nm, but is not limited thereto. Since a critical thickness at which each ferroelectric material exhibits ferroelectric properties may be different, the thickness of the ferroelectric material layer may vary depending on the ferroelectric material.

In one example, the first gate insulating layer 130 may be formed of a single homogenous ferroelectric material layer. In another example, the first gate insulating layer 130 may include a plurality of ferroelectric material layers spaced apart from each other. The first gate insulating layer 130 may have a laminated layer structure in which a plurality of ferroelectric material layers and a plurality of paraelectric material layers are alternately disposed on each other.

The first gate spacer 140 may be disposed on a sidewall 120SW of the first gate electrode. The first gate spacer 140 may not be disposed between the first lower pattern BP1 and the first sheet pattern NS1, and between the first sheet patterns NS1 adjacent in the third direction D3.

The first gate spacer 140 may include a first spacer layer 141 and a second spacer layer 142. The second spacer layer 142 may be disposed on the first spacer layer 141. The first spacer layer 141 may be disposed between the first gate electrode 120 and the second spacer layer 142. The first spacer layer 141 may be in contact with the first gate insulating layer 130 and the second spacer layer 142.

The first spacer layer 141 may include an extension portion 141EX and a protrusion portion 141PR. The extension portion 141EX of the first spacer layer may extend in the second direction D2 along the sidewall 120SW of the first gate electrode.

The protrusion portion 141PR of the first spacer layer may protrude in the first direction D1 from the extension portion 141EX of the first spacer layer. The protrusion portion 141PR of the first spacer layer may include a terminal end 141PR_TP located farthest from the extension portion 141EX of the first spacer layer. The terminal end 141PR_TP of the protrusion portion of the first spacer layer is the point located farthest from the sidewall 120SW of the first gate electrode.

In cross-sectional view of FIG. 2, the first spacer layer 141 may have an L shape, for example. In plan views of FIGS. 5 and 6, the first spacer layer 141 may have an L shape, for example.

The first gate spacer 140 may include an inner wall 140ISW, a connection sidewall 140CSW, and an outer wall 140OSW. The inner wall 140ISW of the first gate spacer faces the sidewall 120SW of the first gate electrode extending in the second direction D2. The inner wall 140ISW of the first gate spacer may extend in the second direction D2.

The outer wall 140OSW of the first gate spacer may extend in the second direction D2. The outer wall 140OSW of the first gate spacer may be opposite to the inner wall 140ISW of the first gate spacer in the first direction D1. The connection sidewall 140CSW of the first gate spacer is connected to the inner wall 140ISW of the first gate spacer. The connection sidewall 140CSW of the first gate spacer may extend in the first direction D1. For example, in cross-sectional views of FIGS. 2 and 7, the connection sidewall 140CSW of the first gate spacer may not be connected to the outer wall 140OSW of the first gate spacer. In plan views of FIGS. 5 and 6, the connection sidewall 140CSW of the first gate spacer may not be connected to the outer wall 140OSW of the first gate spacer.

The second spacer layer 142 may extend along the sidewall 120SW of the first gate electrode. In cross-sectional views of FIGS. 2 and 7, a part of the second spacer layer 142 may extend along the upper surface 150US of the first source/drain pattern. On the sidewall 120SW of the first gate electrode, the first spacer layer 141 may be disposed between the second spacer layer 142 and the first gate electrode 120. On the upper surface 150US of the first source/drain pattern, the first spacer layer 141 is not disposed between the second spacer layer 142 and the first source/drain pattern 150. For example, the second spacer layer 142 may be in contact with the upper surface 150US of the first source/drain pattern.

A thickness t12 of the second spacer layer 142 on the sidewall 120SW of the first gate electrode may be greater than or equal to a thickness 111 of the second spacer layer 142 on the upper surface 150US of the first source/drain pattern. For example, the thickness t12 of the second spacer layer 142 on the sidewall 120SW of the first gate electrode is greater than the thickness t1 1 of the second spacer layer 142 on the upper surface 150US of the first source/drain pattern.

The first gate insulating layer 130 may extend along the inner wall 140ISW of the first gate spacer. The first gate insulating layer 130 may be in contact with the inner wall 140ISW of the first gate spacer.

The first spacer layer 141 includes the inner wall 140ISW of the first gate spacer. The entire inner wall 140ISW of the first gate spacer may be defined by the first spacer layer 141, and in particular it may be defined by the extension portion 141EX of the first spacer layer.

The first spacer layer 141 includes the connection sidewall 140CSW of the first gate spacer. At least a part of the connection sidewall 140CSW of the first gate spacer may be defined by the first spacer layer 141. For example, the entire connection sidewall 140CSW of the first gate spacer may be defined by the first spacer layer 141, and in particular it may be defined by the protrusion portion 141PR of the first spacer layer.

The first spacer layer 141 and the second spacer layer 142 may be formed of different insulating materials. The first spacer layer 141 and the second spacer layer 142 may each include, for example, at least one of silicon nitride (SiN), silicon oxynitride (SiON), silicon oxide (SiO₂), silicon oxynitride (SiOCN), silicon boron nitride (SiBN), silicon oxyboron nitride (SiOBN), or silicon oxycarbide (SiOC). The dielectric constant of the second spacer layer 142 may be smaller than that of the first spacer layer 141, but the present invention is not limited thereto.

The first gate capping pattern 145 may be disposed on the first gate electrode 120 and the first gate spacer 140. The upper surface of the first gate capping pattern 145 may be on the same plane as (i.e., coplanar with) the upper surface of the first interlayer insulating layer 190, but the present invention is not limited thereto. Unlike the illustrated example, the first gate capping pattern 145 may be disposed between the first gate spacers 140.

The first gate capping pattern 145 may be formed of, for example, at least one of silicon nitride (SiN), silicon oxynitride (SiON), silicon carbonitride (SiCN), silicon oxycarbonitride (SiOCN), or a combination thereof. The first gate capping pattern 145 may include, for example, a material having an etch selectivity with respect to the first interlayer insulating layer 190.

The first source/drain pattern 150 may be disposed on the first active pattern AP1. The first source/drain pattern 150 may be disposed on the first lower pattern BP1. The first source/drain pattern 150 is connected to the first sheet pattern NS1.

The first source/drain pattern 150 may be disposed on the side surface of the first gate structure GS1. The first source/drain pattern 150 may be disposed between the first gate structures GS1 adjacent in the first direction D1. For example, the first source/drain pattern 150 may be disposed on both sides of the first gate structure GS1. Unlike the illustrated example, the first source/drain pattern 150 may be disposed on one side of the first gate structure GS1 and may not be disposed on the other side of the first gate structure GS1.

The first source/drain pattern 150 may be included in a source/drain of a transistor using the first sheet pattern NS1 as a channel region.

The first source/drain pattern 150 may be disposed in a first source/drain recess 150R. The first source/drain recess 150R extends in the third direction D3. The first source/drain recess 150R may be defined between the first gate structures GS1 adjacent in the first direction D1.

The bottom surface of the first source/drain recess 150R is defined by the first lower pattern BP1. The sidewall of the first source/drain recess 150R may be defined by the first sheet pattern NS1 and the inner gate structures INT1_GS1, INT2_GS1, and INT3_GS1. The inner gate structures INT1_GS1, INT2_GS1, and INT3_GS1 may define a part of the sidewall of the first source/drain recess 150R. In FIGS. 5 and 6, the first source/drain recess 150R includes the connection sidewall 140CSW of the first gate spacer.

The inner gate structures INT1_GS1, INT2_GS1, and INT3_GS1 may include upper surfaces facing the bottom surface NS1_BS of the first sheet pattern. The inner gate structures INT1_GS1, INT2_GS1, and INT3_GS1 include bottom surfaces facing the upper surface NS1_US of the first sheet pattern or the upper surface BP1_US of the first lower pattern. The inner gate structures INT1_GS1, INT2_GS1, and INT3_GS1 include sidewalls connecting the upper surfaces of the inner gate structures INT1_GS1, INT2_GS1, and INT3_GS1 and the bottom surfaces of the inner gate structures INT1_GS1, INT2_GS1, and INT3_GS1. The sidewalls of the inner gate structures INT1_GS1, INT2_GS1, and INT3_GS1 may define a part of the sidewall of the first source/drain recess 150R.

Between the lowermost first sheet pattern NS1 and the first lower pattern BP1, the boundary between the first gate insulating layer 130 and the first lower pattern BP1 may be the upper surface BP1_US of the first lower pattern. The upper surface BP1_US of the first lower pattern may be the boundary between the third inner gate structure INT3_GS1 and the first lower pattern BP1.

A width extension region 150R_ER of the first source/drain recess may be defined between the first sheet patterns NS1 adjacent in the third direction D3. The width extension region 150R_ER of the first source/drain recess may be defined between the first lower pattern BP1 and the first sheet pattern NS1. The width extension region 150R_ER of the first source/drain recess may extend between the first sheet patterns NS1 adjacent in the third direction D3. The width extension region 150R_ER of the first source/drain recess may be defined between the inner gate structures INT1_GS1, INT2_GS1, and INT3_GS1 adjacent in the first direction D1.

The width extension region 150R_ER of each first source/drain recess may include a portion whose width increases in the first direction D1 and a portion whose width decreases in the first direction D1 as the distance from the upper surface BP1_US of the first lower pattern increases. For example, the width of the width extension region 150R_ER of the first source/drain recess may increase and then decrease as the distance from the upper surface BP1_US of the first lower pattern increases.

In the width extension region 150R_ER of each first source/drain recess, the point at which the width of the width extension region 150R_ER of the first source/drain recess is maximum may be located between the first sheet pattern NS1 and the first lower portion BP1, or between the first sheet patterns NS1 adjacent in the third direction D3.

The first source/drain pattern 150 may be in contact with the first sheet pattern NS1 and the first lower pattern BP1. A part of the first source/drain pattern 150 may be in contact with the connection sidewall 140CSW of the first gate spacer. The first gate insulating layer 130 of the inner gate structures INT1_GS1, INT2_GS1, and INT3_GS1 may be in contact with the first source/drain pattern 150.

The first source/drain pattern 150 may include and/or be an epitaxial pattern. The first source/drain pattern 150 includes a semiconductor material. The first source/drain pattern 150 may include a semiconductor liner layer 151, and a semiconductor filling layer 152.

The semiconductor liner layer 151 may be continuously formed along the first source/drain recess 150R. The semiconductor liner layer 151 may be formed along the sidewall of the first source/drain recess 150R and the bottom surface of the first source/drain recess 150R. The semiconductor liner layer 151 formed along the first source/drain recess 150R defined by the first sheet pattern NS1 is directly connected to the semiconductor liner layer 151 formed along the first source/drain recess 150R defined by the inner gate structures INT1_GS1, INT2_GS1, and INT3_GS1.

The semiconductor liner layer 151 may be in contact with the first active pattern AP1 and the inner gate structures INT1_GS1, INT2_GS1, and INT3_GS1. The semiconductor liner layer 151 is in contact with the first gate insulating layer 130, the first sheet pattern NS1, and the first lower pattern BP1. The semiconductor liner layer 151 may be in contact with the first gate spacer 140. The semiconductor liner layer 151 is in contact with the connection sidewall 140CSW of the first gate spacer.

The semiconductor liner layer 151 may include an outer surface 151OSW and an inner surface 151ISW. The outer surface 1510SW of the semiconductor liner layer may be in contact with the first active pattern AP1 and the inner gate structures INT1_GS1, INT2_GS1, and INT3_GS_1. The outer surface 151OSW of the semiconductor liner layer is in contact with the first gate insulating layer 130, the first sheet pattern NS1, and the first lower pattern BP1. The outer surface 151OSW of the semiconductor liner layer is directly connected to the first sidewall NS1_SW1 of the first sheet pattern. The outer surface 151OSW of the semiconductor liner layer may represent the profile of the first source/drain recess 150R.

The inner surface 151ISW of the semiconductor liner layer may be a surface opposite to the outer surface 151OSW of the semiconductor liner layer. The inner surface 151ISW of the semiconductor liner layer may be a surface facing the semiconductor filling layer 152.

In plan views of FIGS. 5 and 6, the inner surface 151ISW of the semiconductor liner layer may include a concave region 151ISW_CV and convex regions 151ISW_CX1 and 151ISW_CX2. On the inner surface 151ISW of the semiconductor liner layer, the concave region 151ISW_CV may be located between the first convex region 151ISW_CX1 and the second convex region 151ISW_CX2. The concave region 151ISW_CV and the convex regions 151ISW_CX1 and 151ISW_CX2 are illustrated as curved surfaces, but the present invention is not limited thereto. At least one of the concave regions 151ISW_CV and the convex regions 151ISW_CX1 and 151ISW_CX2 may include a flat surface portion corresponding to a crystal plane of the semiconductor material of the semiconductor liner layer.

In FIGS. 5 and 6, the inner surface 151ISW of the semiconductor liner layer may include a first point PS1, a second point PS2, and a third point PS3. The first point PS1 of the inner surface 151ISW of the semiconductor liner layer may be a point where the inner surface 151ISW of the semiconductor liner layer is in contact with the connection sidewall 140CSW of the first gate spacer. The third point PS3 of the inner surface 151ISW of the semiconductor liner layer may be the center point of the inner surface 151ISW of the semiconductor liner layer. The third point PS3 of the inner surface 151ISW of the semiconductor liner layer may be located at the center of the semiconductor liner layer 151 in the second direction D2. The second point PS2 of the inner surface 151ISW of the semiconductor liner layer is located between the first point PS1 of the inner surface 151ISW of the semiconductor liner layer and the third point PS3 of the inner surface 151ISW of the semiconductor liner layer.

The first point PS1 of the inner surface 151ISW of the semiconductor liner layer may be spaced apart from the inner wall 140ISW of the first gate spacer by a first distance L11 in the first direction D1. The first distance L11 may be a distance at which the first point PS1 is spaced apart in the first direction D1 from the inner wall 140ISW of the first gate spacer or from the extension line of the inner wall 140ISW of the first gate spacer. The extension line of the inner wall 140ISW of the first gate spacer may be an imaginary line extending from the inner wall 140ISW of the first gate spacer in the second direction D2.

The second point PS2 of the inner surface 151ISW of the semiconductor liner layer may be spaced apart from the inner wall 140ISW of the first gate spacer by a second distance L12 in the first direction D1. The third point PS3 of the inner surface 151ISW of the semiconductor liner layer may be spaced apart from the inner wall 140ISW of the first gate spacer by a third distance L13 in the first direction D1. The terminal end 141PR_TP of the protrusion portion of the first spacer layer may be spaced apart from the inner wall 140ISW of the first gate spacer by a fourth distance L14 in the first direction D1.

The first distance L11 may be different from the second distance L12. The third distance L13 may be different from the second distance L12. For example, the first distance L11 may be smaller than the second distance L12. The third distance L13 may be smaller than the second distance L12. In FIGS. 5 and 6, the second point PS2 of the inner surface 151ISW of the semiconductor liner layer may be located in the convex regions 151ISW_CX1 and 151ISW_CX2 of the inner surface 151ISW of the semiconductor liner layer.

In FIGS. 5 and 6, the inner surface 151ISW of the semiconductor liner layer may include a point 151ISW_SP located farthest from the inner wall 140ISW of the first gate spacer in the first direction D1 (which may be referred to herein as a separation point). For example, the second point PS2 of the inner surface 151ISW of the semiconductor liner layer may be the separation point 151ISW_SP of the inner surface 151ISW of the semiconductor liner layer.

The fourth distance L14 may be greater than the first distance L11. In plan view, the semiconductor liner layer 151 does not extend to the terminal end 141PR_TP of the protrusion portion of the first spacer layer.

A part of the semiconductor liner layer 151 may protrude toward the semiconductor filling layer 152 beyond the first spacer layer 141 in the first direction D1. The semiconductor liner layer 151 may include the protrusion portion 151PR of the semiconductor liner layer. The protrusion portion 151PR of the semiconductor liner layer may be a portion of the semiconductor liner layer 151 that protrudes toward the semiconductor filling layer 152 beyond the terminal end 141PR_TP of the protrusion portion of the first spacer layer. The distance L12 at which the separation point 151ISW_SP of the inner surface 151ISW of the semiconductor liner layer is spaced apart from the inner wall 140ISW of the first gate spacer in the first direction D1 may be greater than the fourth distance L14.

In FIGS. 2, 5, and 6, it is illustrated that the thickness of the semiconductor liner layer 151 in the first direction D1 that is in contact with the first sidewall NS1_SW1 of the first sheet pattern is smaller than the thickness of the semiconductor liner layer 151 in the first direction D1 that is in contact with the inner gate structures INT1_GS1, INT2_GS1, and INT3_GS1, but the present invention is not limited thereto.

In FIGS. 2 and 9, the semiconductor liner layer 151 may be in contact with the entire sidewalls of the inner gate structures INT1_GS1, INT2_GS1, and INT3_GS1.

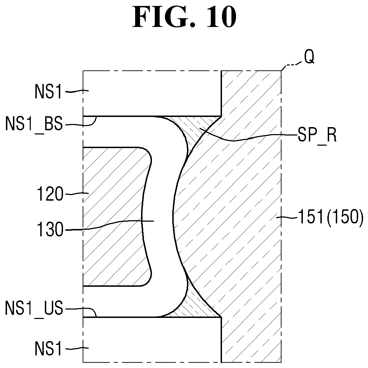

In FIGS. 2 and 10, a semiconductor residue pattern SP_R may be disposed between the semiconductor liner layer 151 and the inner gate structures INT1_GS1, INT2_GS1, and INT3_GS1. The semiconductor residue pattern SP_R may be in contact with the first sheet pattern NS1. The semiconductor residue pattern SP_R may be in contact with the outer surface 151OSW of the semiconductor liner layer and the sidewalls of the inner gate structures INT1_GS1, INT2_GS1, and INT3_GS1.

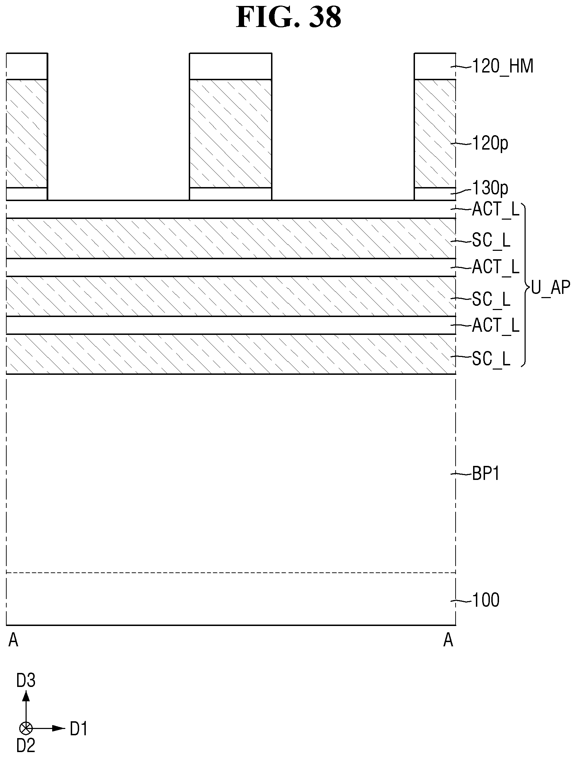

The semiconductor residue pattern SP_R may be formed of silicon-germanium, for example. When the semiconductor liner layer 151 is formed of silicon-germanium, the germanium fraction (e.g., the atomic percentage of germanium) of the semiconductor residue pattern SP_R may be greater than the germanium fraction of the semiconductor liner layer 151. The semiconductor residue pattern SP_R may be the residual portion remaining after a sacrificial pattern SC_L (see FIG. 38) is removed.

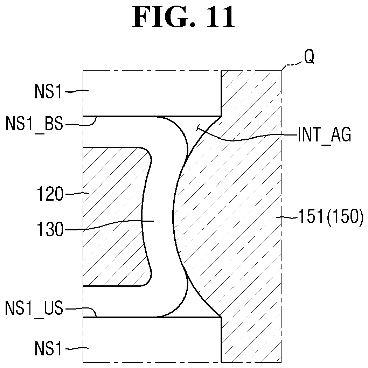

In FIGS. 2 and 11, an inner gate air gap INT_AG may be disposed between the semiconductor liner layer 151 and the inner gate structures INT1_GS1, INT2_GS1, and INT3_GS1. The inner gate air gap INT_AG may be disposed between the semiconductor liner layer 151 and the first gate insulating layer 130 of the inner gate structures INT1_GS1, INT2_GS1, and INT3_GS_1. The inner gate air gap INT_AG may be defined between the semiconductor liner layer 151, the first sheet pattern NS1, and the inner gate structures INT1_GS1, INT2_GS1, and INT3_GS1.

Although not shown, when the first gate insulating layer 130 includes an interfacial layer and a high-k insulating layer, the interfacial layer may be formed on the semiconductor liner layer 151 in contact with the inner gate air gap INT_AG.

The semiconductor liner layer 151 may be formed of silicon-germanium, for example. The semiconductor liner layer 151 may be a silicon-germanium layer. The semiconductor liner layer 151 may include doped p-type impurities. For example, the p-type impurities may be of boron (B) and/or gallium (Ga), but the present invention is not limited thereto.

The semiconductor filling layer 152 is disposed on the semiconductor liner layer 151. The semiconductor filling layer 152 may be in contact with the semiconductor liner layer 151. In FIG. 2, the semiconductor filling layer 152 may fill the rest of the first source/drain recess 150R. For example, the upper surface 152US of the semiconductor filling layer may be the upper surface 150US of the first source/drain pattern.

The semiconductor filling layer 152 is disposed on the inner surface 151ISW of the semiconductor liner layer. For example, the entire inner surface 151ISW of the semiconductor liner layer may be in contact with the semiconductor filling layer 152.

In FIGS. 2 and 7, the semiconductor filling layer 152 may be divided into an upper portion 152UP and a bottom portion 152BP with respect to the upper surface AP1_US of the first active pattern. The semiconductor filling layer 152 may include the upper portion 152UP of the semiconductor filling layer that protrudes in the third direction D3 beyond the upper surface AP1_US of the first active pattern.

The upper portion 152UP of the semiconductor filling layer may include an upper facet surface 152UP_FC. The upper facet surface 152UP_FC may be a crystal surface of a semiconductor material, or may be a surface inclined with respect to the upper surface of the protrusion portion 141PR of the first spacer layer. The protrusion portion 141PR of the first spacer layer may include a bottom surface facing the upper surface AP1_US of the first active pattern. The upper surface of the protrusion portion 141PR of the first spacer layer may be opposite to the bottom surface of the protrusion portion 141PR of the first spacer layer in the third direction D3.

The upper facet surface 152UP_FC of the upper portion 152UP of the semiconductor filling layer may extend from the terminal end 141PR_TP of the protrusion portion of the first spacer layer. The upper surface 152US of the semiconductor filling layer does not include the upper facet surface 152UP_FC of the upper portion 152UP of the semiconductor filling layer.

In the semiconductor device according to some embodiments, the upper portion 152UP of the semiconductor filling layer may overlap the protrusion portion 141PR of the first spacer layer in the third direction D3. As illustrated in FIG. 8, a maximum width W12 of the upper portion 152UP of the semiconductor filling layer in the first direction D1 may be greater than a width W11 of the semiconductor filling layer 152 in the first direction D1 on the upper surface AP1_US of the first active pattern. At the terminal end portion of the upper facet surface 152UP_FC of the upper portion 152UP of the semiconductor filling layer, the upper portion 152UP of the semiconductor filling layer may have the maximum width W12 in the first direction D1.

The upper portion 152UP of the semiconductor filling layer may include a portion whose width increases in the first direction D1 as the distance from the upper surface AP1_US of the first active pattern increases. In at least a part of the upper portion 152UP of the semiconductor filling layer, the width of the semiconductor filling layer 152 in the first direction D1 may increase as the distance from the upper surface AP1_US of the first active pattern increases.

The upper portion 152UP of the semiconductor filling layer may not be in contact with the extension portion 141EX of the first spacer layer. The second spacer layer 142 may be disposed between the upper portion 152UP of the semiconductor filling layer and the extension portion 141EX of the first spacer layer.

In FIG. 7, the second spacer layer 142 may completely fill the space between the upper portion 152UP of the semiconductor filling layer and the protrusion portion 141PR_TP of the first spacer layer.

In an alternative, as illustrated in FIG. 8, a spacer air gap 142_AG may be disposed in the space between the upper portion 152UP of the semiconductor filling layer and the protrusion portion 141PR_TP of the first spacer layer.

The semiconductor filling layer 152 may be silicon-germanium, for example. The semiconductor filling layer 152 may be a silicon-germanium layer. The semiconductor filling layer 152 may include doped p-type impurities. The germanium fraction of the semiconductor liner layer 151 may be smaller than the germanium fraction of the semiconductor filling layer 152.

The source/drain etching stop layer 185 may be disposed on the first source/drain pattern 150. The source/drain etching stop layer 185 may extend along the outer wall 140OSW of the first gate spacer. Although not shown, the source/drain etching stop layer 185 may be disposed on the upper surface of the field insulating layer 105.

The source/drain etching stop layer 185 may be in contact with the second spacer layer 142. The second spacer layer 142 is disposed between the source/drain etching stop layer 185 and the first spacer layer 141. The source/drain etching stop layer 185 may extend along the sidewall of the first gate capping pattern 145.

The source/drain etching stop layer 185 may be formed of a material having an etch selectivity with respect to the first interlayer insulating layer 190 to be described later. The source/drain etching stop layer 185 may be formed of, for example, silicon nitride (SiN), silicon oxynitride (SiON), silicon oxycarbonitride (SiOCN), silicon boron nitride (SiBN), silicon oxyboron nitride (SiOBN), silicon oxycarbide (SiOC), or a combination thereof.

The first interlayer insulating layer 190 may be disposed on the source/drain etching stop layer 185. The first interlayer insulating layer 190 may be disposed on the first source/drain pattern 150. The first interlayer insulating layer 190 may not cover the upper surface of the first gate capping pattern 145. For example, the upper surface of the first interlayer insulating layer 190 may be on the same plane as the upper surface of the first gate capping pattern 145.

The first interlayer insulating layer 190 may be formed of, for example, at least one of silicon oxide, silicon nitride, silicon oxynitride, or a low-k material. The low-k material may be, for example, fluorinated tetraethylorthosilicate (FTEOS), hydrogen silsesquioxane (HSQ), bis-benzocyclobutene (BCB), tetramethylorthosilicate (TMOS), octamethylcyclotetrasiloxane (OMCTS), hexamethyldisiloxane (HMDS), trimethylsilyl borate (TMSB), diacetoxyditertiarybutosiloxane (DADBS), trimethylsilil phosphate (TMSP), polytetrafluoroethylene (PTFE), tonen silazene (TOSZ), fluoride silicate glass (FSG), polyimide nanofoams such as polypropylene oxide, carbon doped silicon oxide (CDO), organo silicate glass (OSG), SiLK^{™}, amorphous fluorinated carbon, silica aerogels, silica xerogels, mesoporous silica, or a combination thereof, but is not limited thereto.

The first source/drain contact 180 is disposed on the first source/drain pattern 150. The first source/drain contact 180 is connected to the first source/drain pattern 150. The first source/drain contact 180 may be connected to the first source/drain pattern 150 while passing through the first interlayer insulating layer 190, the source/drain etching stop layer 185, and the second spacer layer 142.

In cross-sectional view of FIG. 2, it is illustrated that the first source/drain contact 180 is not in contact with a portion of the source/drain etching stop layer 185 that extends along the sidewall of the first gate structure GS1, but the present invention is not limited thereto. Unlike the drawing, for example, the first source/drain contact 180 may be in contact with a portion of the source/drain etching stop layer 185 that, in alternative embodiments, extends along the sidewall of the first gate structure GS1. As another example, the first source/drain contact 180 may be in contact with the first gate capping pattern 145.

A first metal silicide layer 155 may be further disposed between the first source/drain contact 180 and the first source/drain pattern 150.

Although it is illustrated that the first source/drain contact 180 is a single layer, this is merely for simplicity of description, and the present invention is not limited thereto. The first source/drain contact 180 may be formed of, for example, at least one of a metal, a metal alloy, a conductive metal nitride, a conductive metal carbide, a conductive metal oxide, a conductive metal carbonitride, or one or more two-dimensional (2D) material layers.

A second interlayer insulating layer 191 is disposed on the first interlayer insulating layer 190. The second interlayer insulating layer 191 may be formed of, for example, at least one of silicon oxide, silicon nitride, silicon oxynitride, or a low-k material.

The wiring structure 205 is disposed in the second interlayer insulating layer 191. The wiring structure 205 may be connected to the first source/drain contact 180. The wiring structure 205 may include a wiring line 207 and a wiring via 206.

Although it is illustrated that the wiring line 207 and the wiring via 206 are distinguished from each other, this is merely for simplicity of description, and the present invention is not limited thereto. That is, for example, the wiring line 207 may be formed after the wiring via 206 is formed. As another example, the wiring via 206 and the wiring line 207 may be formed at the same time.

Although it is illustrated that each of the wiring line 207 and the wiring via 206 is a single layer, it is merely for simplicity of description, and the present invention is not limited thereto. Each of the wiring line 207 and the wiring via 206 may be formed of, for example, at least one of a metal, a metal alloy, a conductive metal nitride, a conductive metal carbide, a conductive metal oxide, a conductive metal carbonitride, or one or more two-dimensional (2D) material layers.

For example, the upper surface of the first source/drain contact 180 at a portion that is connected to the wiring structure 205 may be located on the same plane as the upper surface of the first source/drain contact 180 at a portion that is not connected to the wiring structure 205.

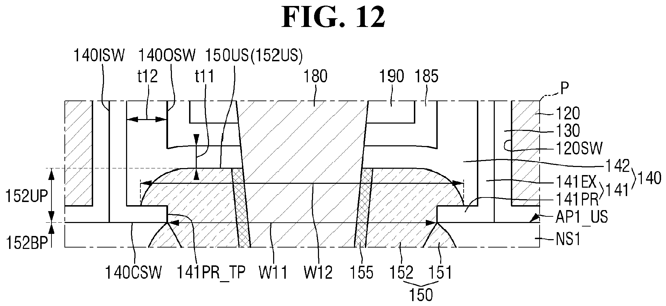

FIGS. 12 to 14 are diagrams each illustrating a semiconductor device according to some embodiments. For simplicity of description, the following description will focus on differences from the description with reference to FIGS. 1 to 11.

For reference, FIGS. 12 to 14 are enlarged views of part P of FIG. 2.

Referring to FIG. 12, in the semiconductor device according to some embodiments, the upper portion 152UP of the semiconductor filling layer does not include the upper facet surface 152UP_FC (see FIG. 7).

The upper portion 152UP of the semiconductor filling layer is in contact with a part of the upper surface of the protrusion portion 141PR of the first spacer layer. On the upper surface of the protrusion portion 141PR of the first spacer layer, the upper portion 152UP of the semiconductor filling layer may have the maximum width W12 in the first direction D1. For example, the upper portion 152UP of the semiconductor filling layer may have a mushroom shape. such as a cap shape having rounded edges.

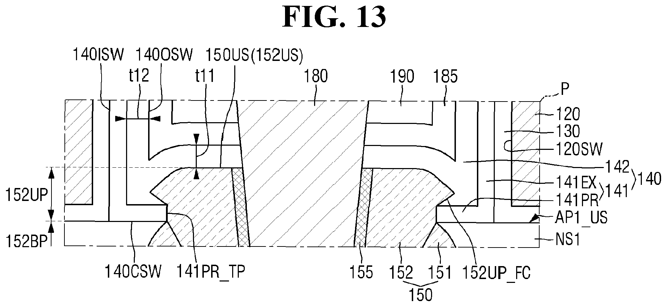

Referring to FIG. 13, in the semiconductor device according to some embodiments, the thickness 112 of the second spacer layer 142 on the sidewall 120SW of the first gate electrode may be the same as the thickness t11 of the second spacer layer 142 on the upper surface 150US of the first source/drain pattern.

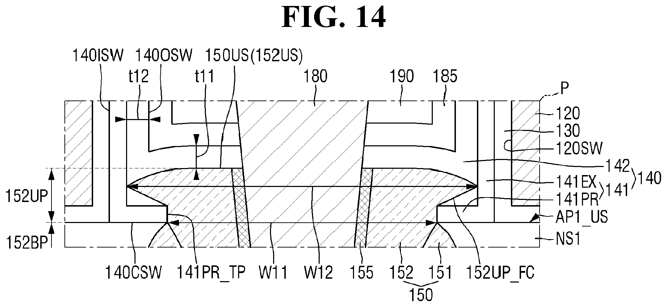

Referring to FIG. 14, in the semiconductor device according to some embodiments, the upper portion 152UP of the semiconductor filling layer may be in contact with the extension portion 141EX of the first spacer layer.

Further, the thickness t12 of the second spacer layer 142 on the sidewall 120SW of the first gate electrode may be the same as the thickness t11 of the second spacer layer 142 on the upper surface 150US of the first source/drain pattern.

Although not shown, the upper portion 152UP of the semiconductor filling layer having the same shape as that shown in FIG. 12 may also be in contact with the extension portion 141EX of the first spacer layer.

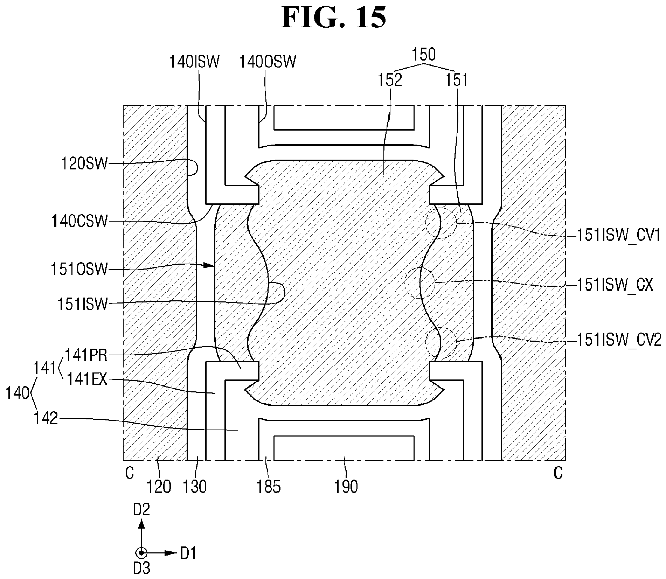

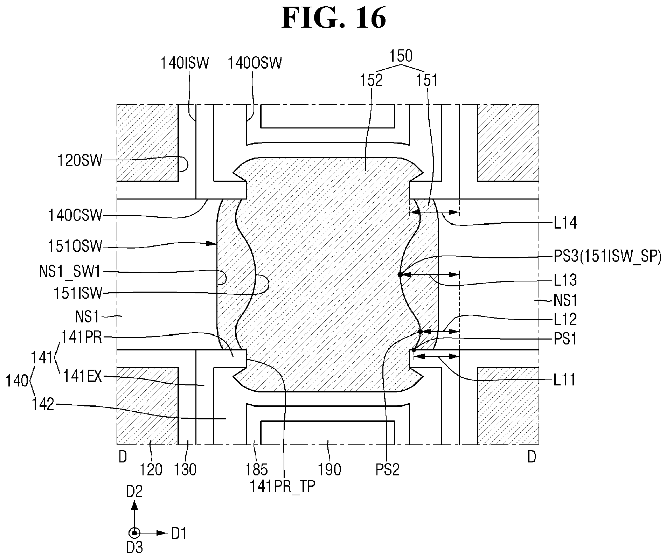

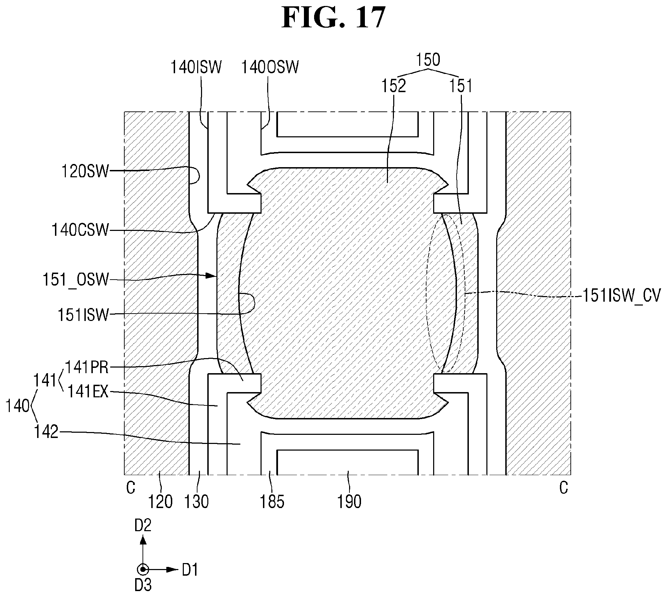

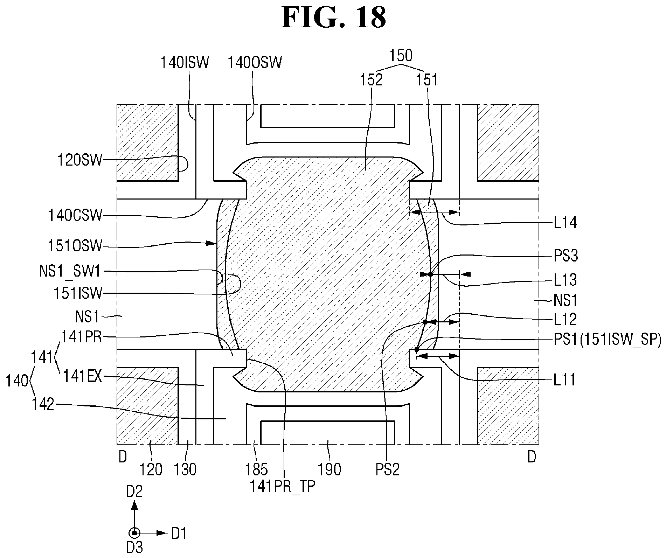

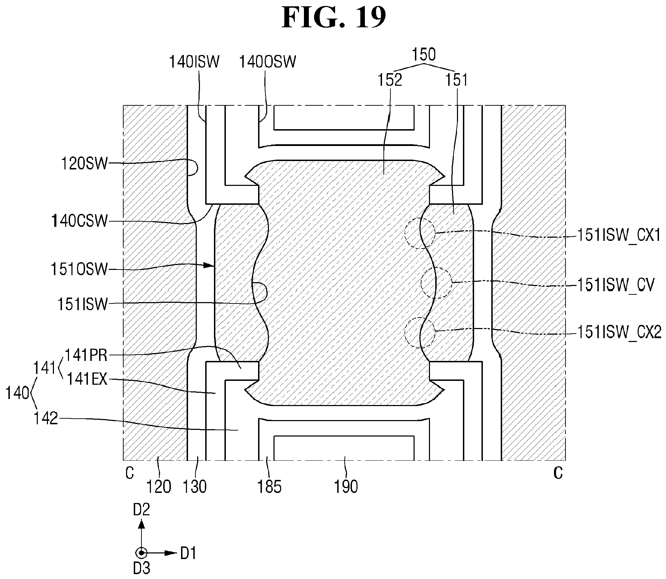

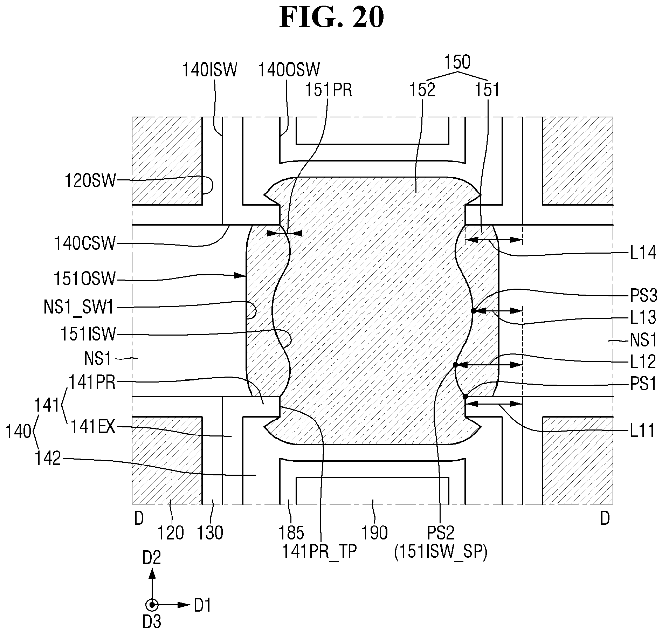

FIGS. 15 and 16 are diagrams illustrating a semiconductor device according to some embodiments. FIGS. 17 and 18 are diagrams illustrating a semiconductor device according to some embodiments. FIGS. 19 and 20 are diagrams illustrating a semiconductor device according to some embodiments. FIGS. 15-20 show various alternatives to the embodiments of FIGS. 1 to 11. For simplicity of description, the following description will focus on differences from the description with reference to FIGS. 1 to 11.

For reference, FIGS. 15, 17, and 19 are top plan views taken along line C-C of FIG. 2. FIGS. 16, 18 and 20 are top plan views taken along line D-D of FIG. 2.

Referring to FIGS. 15 and 16, in the semiconductor device according to some embodiments, the inner surface 151ISW of the semiconductor liner layer may include a concave region 151ISW_CV1 and 151ISW_CV2 and a convex region 151ISW_CX.

On the inner surface 151ISW of the semiconductor liner layer, the convex region 151ISW_CX may be located between the first concave region 151ISW_CV1 and the second concave region 151ISW_CV2.

The first distance L11 may be greater than the second distance L12. The third distance L13 may be greater than the second distance L12. In FIGS. 15 and 16, the third point PS3 of the inner surface 151ISW of the semiconductor liner layer may be located in the convex region 151ISW_CX of the inner surface 151ISW of the semiconductor liner layer. The third point PS3 of the inner surface 151ISW of the semiconductor liner layer may be the separation point 151ISW_SP of the inner surface 151ISW of the semiconductor liner layer.

A part of the semiconductor liner layer 151 may protrude toward the semiconductor filling layer 152 in the first direction D1 beyond the terminal end 141PR_TP of the protrusion portion of the first spacer layer. For example, the distance L13 at which the separation point 151ISW_SP of the inner surface 151ISW of the semiconductor liner layer is spaced apart from the inner wall 140ISW of the first gate spacer in the first direction D1 may be greater than the fourth distance L14.

Unlike the drawing, a part of the semiconductor liner layer 151 may not protrude toward the semiconductor filling layer 152 in the first direction D1 beyond the terminal end 141PR_TP of the protrusion portion of the first spacer layer. For example, the distance L13 at which the separation point 151ISW_SP of the inner surface 151ISW of the semiconductor liner layer is spaced apart from the inner wall 140ISW of the first gate spacer in the first direction D1 may be greater than or equal to the fourth distance L14. As another example, the separation point 151ISW_SP of the inner surface 151ISW of the semiconductor liner layer may be the first point PS1 of the inner surface 151ISW of the semiconductor liner layer.

Referring to FIGS. 17 and 18, in the semiconductor device according to some embodiments, the inner surface 151ISW of the semiconductor liner layer may include only the concave region 151ISW_CV, and may not include the convex region.

The first distance L11 may be greater than the second distance L12. The third distance L13 may be smaller than the second distance L12. The first point PS3 of the inner surface 151ISW of the semiconductor liner layer may be the separation point 151ISW_SP of the inner surface 151ISW of the semiconductor liner layer.

A part of the semiconductor liner layer 151 may not protrude toward the semiconductor filling layer 152 in the first direction D1 beyond the terminal end 141PR_TP of the protrusion portion of the first spacer layer.

Referring to FIGS. 19 and 20, in the semiconductor device according to some embodiments, the fourth distance L14 is the same as the first distance L11.

In plan view, the semiconductor liner layer 151 may extend to the terminal end 141PR_TP of the protrusion portion of the first spacer layer.

As shown in FIG. 20, in plan view taken along the first sheet pattern NS1, the entire connection sidewall 140CSW of the first gate spacer defined by the first spacer layer 141 may be in contact with the first sheet pattern NS1 included in the first active pattern AP1 and the semiconductor liner layer 151.

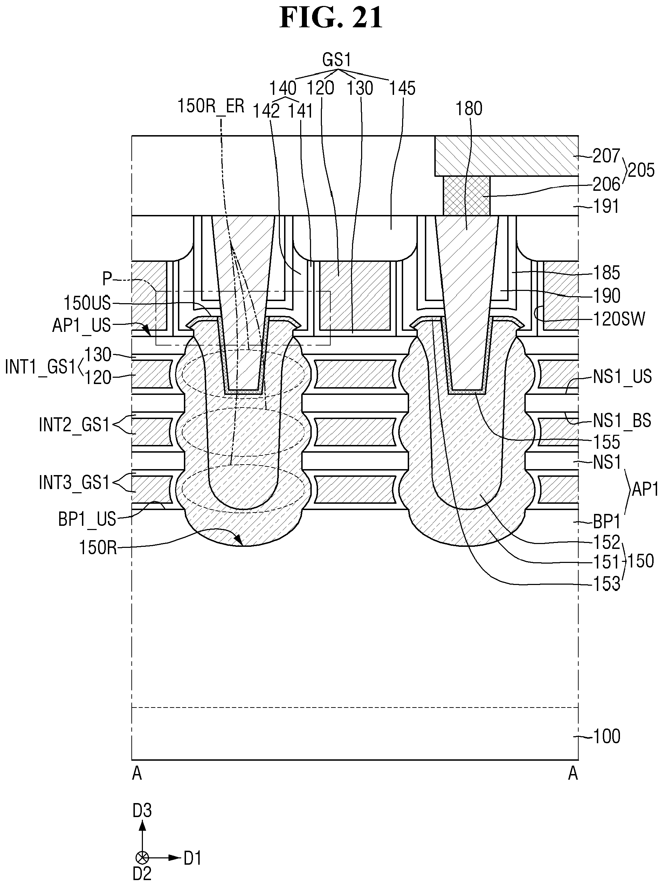

FIGS. 21 to 23 are diagrams illustrating a semiconductor device according to some embodiments. For simplicity of description, the following description will focus on differences from the description with reference to FIGS. 1 to 11.

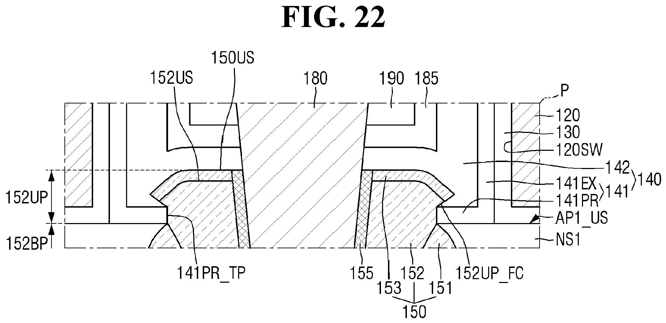

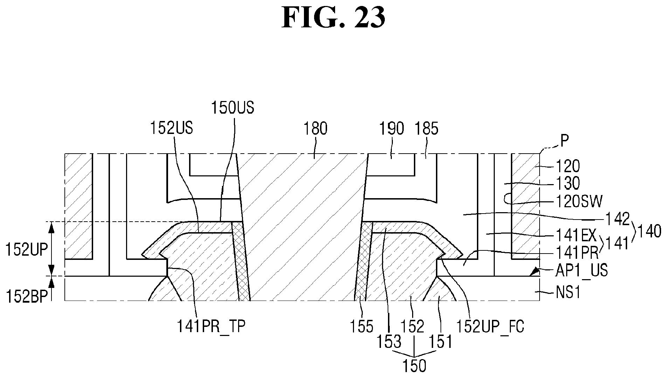

For reference, FIGS. 22 and 23 are enlarged views of part P of FIG. 21.

Referring to FIGS. 21 to 23, in the semiconductor device according to some embodiments, the first source/drain pattern 150 may further include a semiconductor capping layer 153 disposed on the semiconductor filling layer 152.

The semiconductor capping layer 153 is in contact with the semiconductor filling layer 152. The semiconductor capping layer 153 is not in contact with the semiconductor liner layer 151. The semiconductor capping layer 153 includes the upper surface 150US of the first source/drain pattern.

The germanium fraction of the semiconductor capping layer 153 is smaller than the germanium fraction of the semiconductor filling layer 152. For example, the semiconductor capping layer 153 may be silicon-germanium. The semiconductor capping layer 153 may be a silicon-germanium layer. As another example, the semiconductor capping layer 153 may be silicon. The semiconductor capping layer 153 may be a silicon layer.

The semiconductor capping layer 153 may extend along the upper surface 152US of the semiconductor filling layer. The semiconductor capping layer 153 may be in contact with the upper surface 152US of the semiconductor filling layer.

In FIG. 22, the semiconductor capping layer 153 does not extend along the upper facet surface 152UP_FC of the upper portion 152UP of the semiconductor filling layer. The semiconductor capping layer 153 does not cover the upper facet surface 152UP_FC of the upper portion 152UP of the semiconductor filling layer.

In FIG. 23, the semiconductor capping layer 153 extends along the upper facet surface 152UP_FC of the upper portion 152UP of the semiconductor filling layer. The semiconductor capping layer 153 may cover the upper facet surface 152UP_FC of the upper portion 152UP of the semiconductor filling layer.

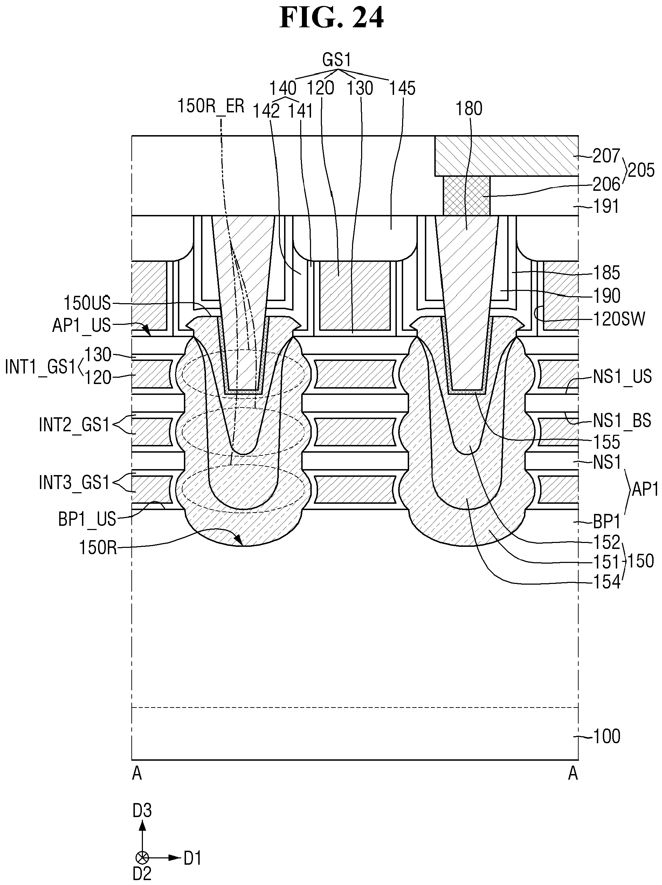

FIGS. 24 to 26 are diagrams each illustrating a semiconductor device according to some embodiments. For simplicity of description, the following description will focus on differences from the description with reference to FIGS. 1 to 11.

Referring to FIG. 24, in the semiconductor device according to some embodiments, the first source/drain pattern 150 may further include a first semiconductor insertion layer 154 disposed between the semiconductor liner layer 151 and the semiconductor filling layer 152.

The first semiconductor insertion layer 154 may be disposed on the semiconductor liner layer 151. The first semiconductor insertion layer 154 is in contact with the semiconductor liner layer 151.

The first semiconductor insertion layer 154 may be silicon-germanium. The first semiconductor insertion layer 154 may be a silicon-germanium layer. The first semiconductor insertion layer 154 may include doped p-type impurities.

The germanium fraction of the first semiconductor insertion layer 154 is smaller than the germanium fraction of the semiconductor filling layer 152. For example, the germanium fraction of the first semiconductor insertion layer 154 is greater than the germanium fraction of the semiconductor liner layer 151. As another example, the germanium fraction of the first semiconductor insertion layer 154 is smaller than the germanium fraction of the semiconductor liner layer 151.

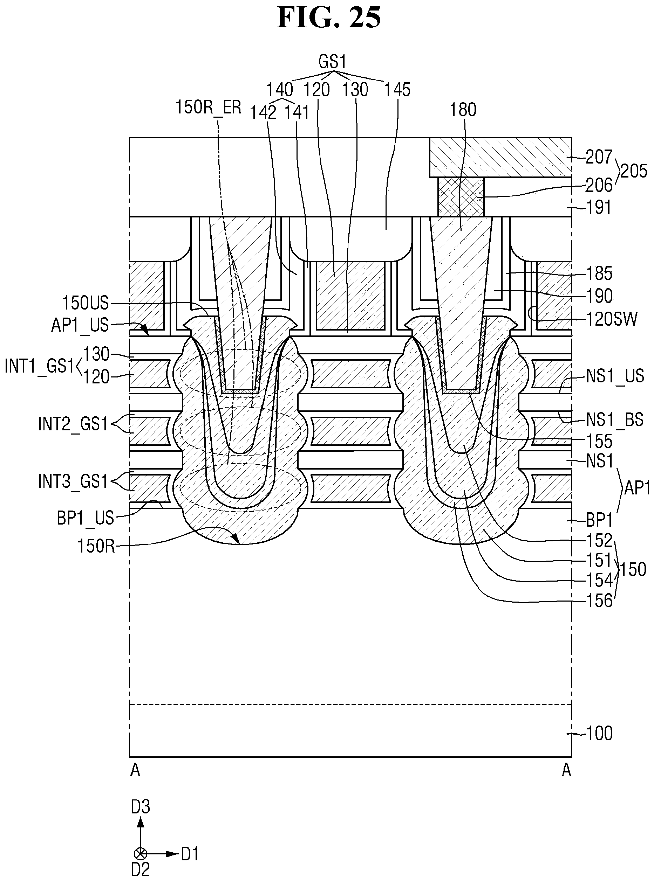

Referring to FIG. 25, in the semiconductor device according to some embodiments, the first source/drain pattern 150 may further include the first semiconductor insertion layer 154 and a second semiconductor insertion layer 156 disposed between the semiconductor liner layer 151 and the semiconductor filling layer 152.

The second semiconductor insertion layer 156 may be disposed between the semiconductor liner layer 151 and the first semiconductor insertion layer 154. The first semiconductor insertion layer 154 may be disposed between the second semiconductor insertion layer 156 and the semiconductor filling layer 152.

Each of first semiconductor insertion layer 154 and the second semiconductor insertion layer 156 may be a silicon-germanium layer including doped p-type impurities. The germanium fraction of the second semiconductor insertion layer 156 may be smaller than the germanium fraction of the first semiconductor insertion layer 154 and the germanium fraction of the semiconductor liner layer 151. The germanium fraction of the first semiconductor insertion layer 154 is greater than the germanium fraction of the semiconductor liner layer 151, and is smaller than the germanium fraction of the semiconductor filling layer 152.

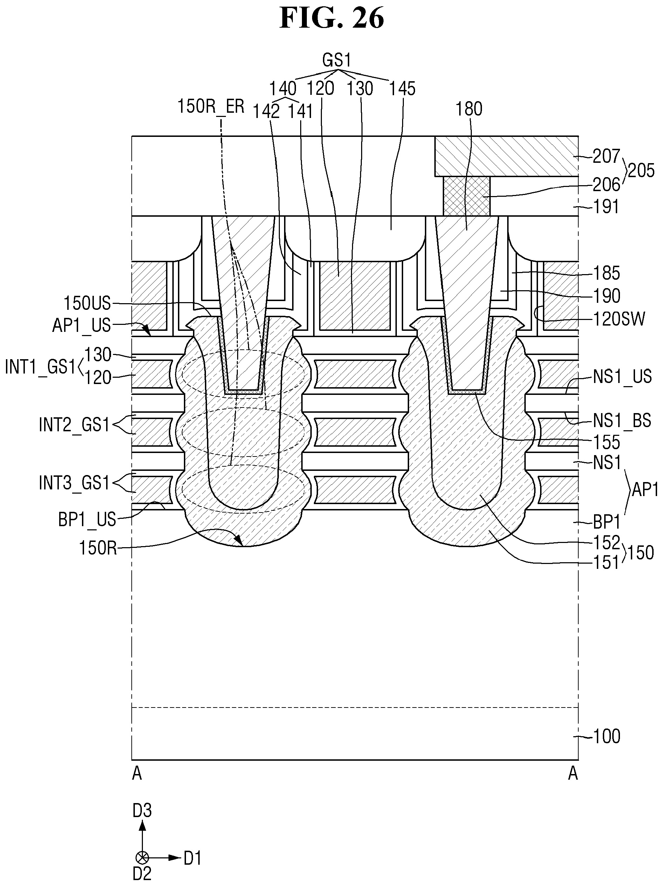

Referring to FIG. 26, in the semiconductor device according to some embodiments, the first gate capping pattern 145 may be disposed on the source/drain etching stop layer 185.

The source/drain etching stop layer 185 may not extend along the sidewall of the first gate capping pattern 145. In cross-sectional view, the upper surface of the first gate capping pattern 145 may be higher than the uppermost portion of the source/drain etching stop layer 185 with respect to the upper surface AP1_US of the first active pattern.

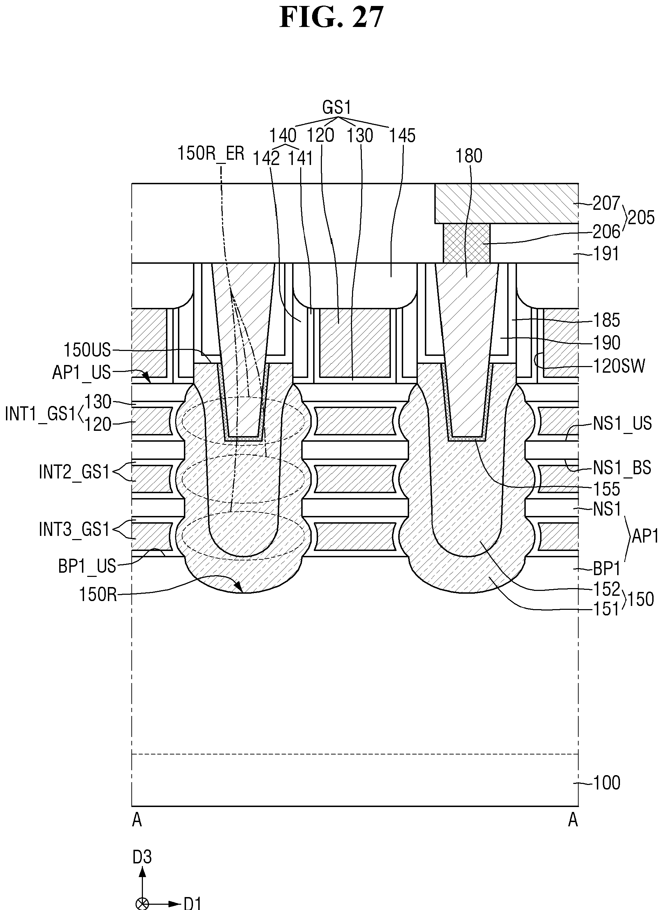

FIGS. 27 to 29 are diagrams illustrating a semiconductor device according to some embodiments. For simplicity of description, the following description will focus on differences from the description with reference to FIGS. 1 to 11.

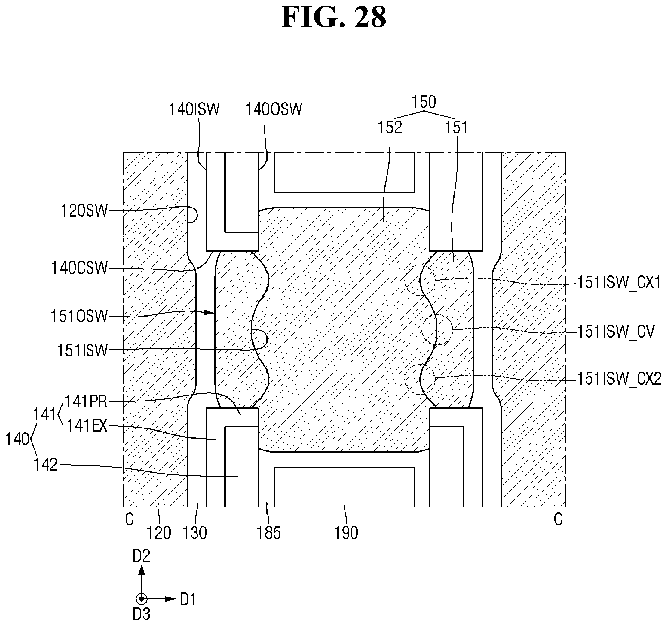

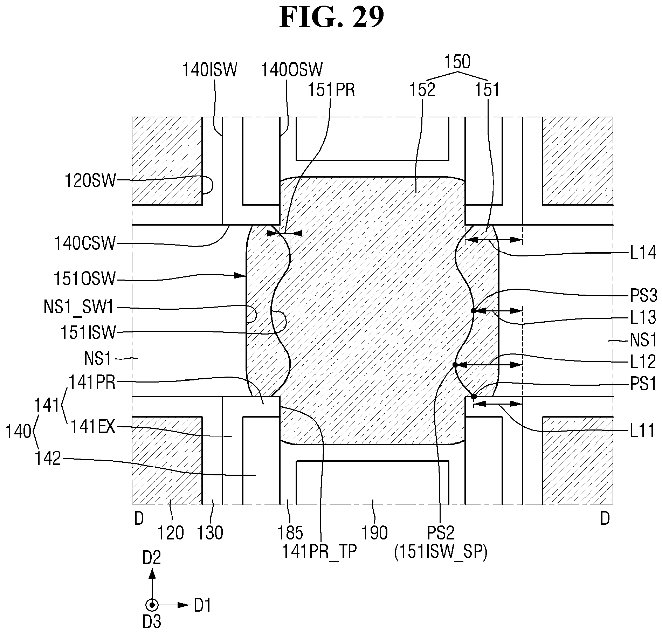

For reference, FIG. 28 is a top plan view taken along line C-C of FIG. 27. FIG. 29 is a top plan view taken along line D-D of FIG. 27.

Referring to FIGS. 27 to 29, in the semiconductor device according to some embodiments, the second spacer layer 142 does not extend along the upper surface 150US of the first source/drain pattern.

The source/drain etching stop layer 185 extending along the upper surface 150US of the first source/drain pattern may be in contact with the upper surface 150US of the first source/drain pattern. The connection sidewall 140CSW of the first gate spacer is connected to the outer wall 140OSW of the first gate spacer.

The semiconductor filling layer 152 does not overlap the protrusion portion 141PR of the first spacer layer in the third direction D3. In the cross-sectional view of FIG. 27, the semiconductor filling layer 152 may be in contact with a part of the outer wall 140OSW of the first gate spacer defined by the second spacer layer 142. At the upper portion of the semiconductor filling layer 152 protruding in the third direction D3 beyond the upper surface AP1_US of the first active pattern, the semiconductor filling layer 152 may not include a portion whose width in the first direction D1 increases as the distance from the upper surface AP1_US of the first active pattern increases.

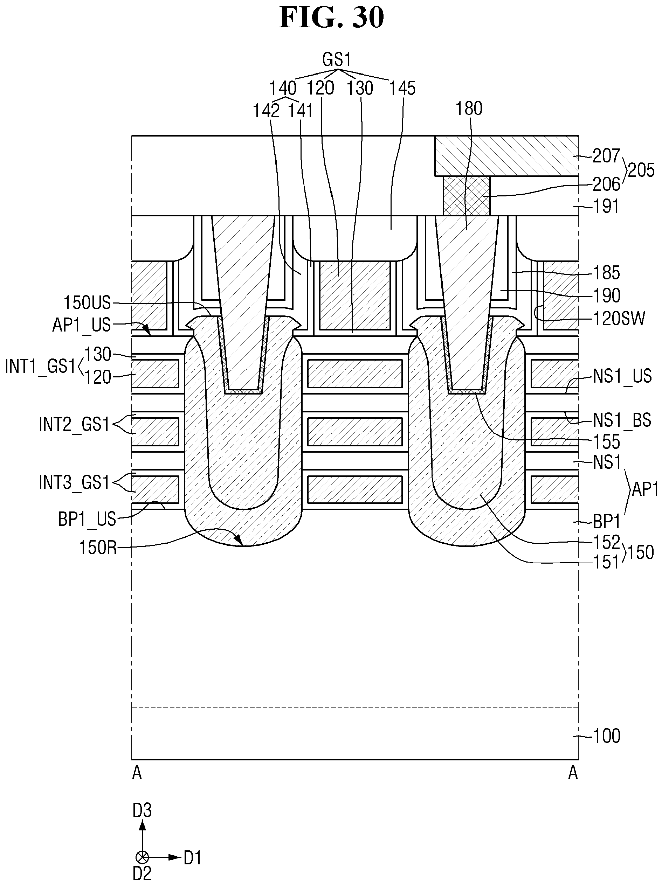

FIGS. 30 to 32 are diagrams each illustrating a semiconductor device according to some embodiments. For simplicity of description, the following description will focus on differences from the description with reference to FIGS. 1 to 11.

Referring to FIG. 30, in the semiconductor device according to some embodiments, the first source/drain recess 150R does not include a plurality of width extension regions 150R_ER (see FIG. 2).

The sidewall of the first source/drain recess 150R may not have a wavy shape. The width of the upper portion of the sidewall of the first source/drain recess 150R in the first direction D1 may decrease as the distance from the first lower pattern BP1 increases.

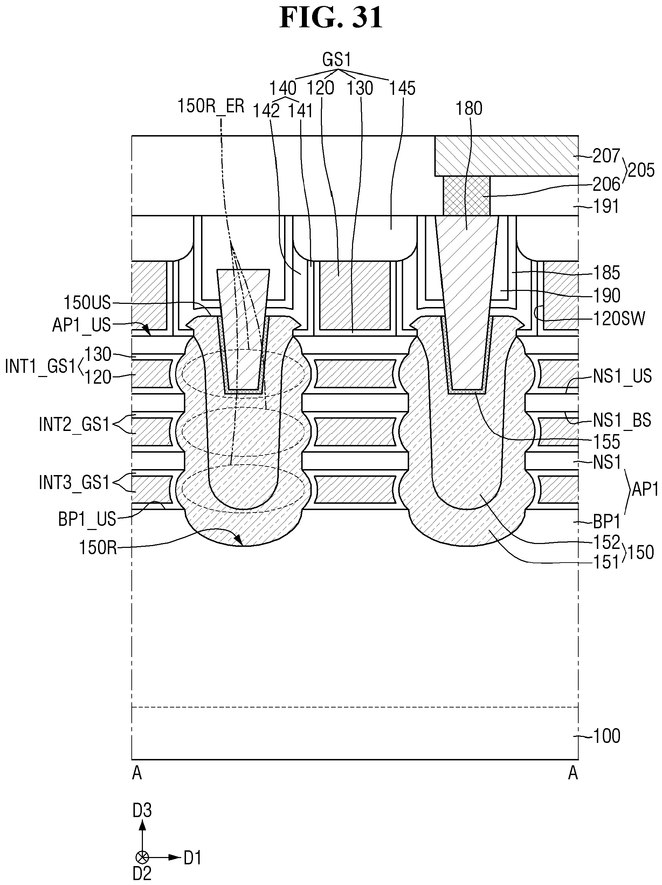

Referring to FIG. 31, in the semiconductor device according to some embodiments, the upper surface of the first source/drain contact 180 at the portion that is not connected to the wiring structure 205 is lower than the upper surface of the first gate capping pattern 145.

The upper surface of the first source/drain contact 180 at the portion that is connected to the wiring structure 205 is higher than the upper surface of the first source/drain contact 180 at the portion that is not connected to the wiring structure 205.

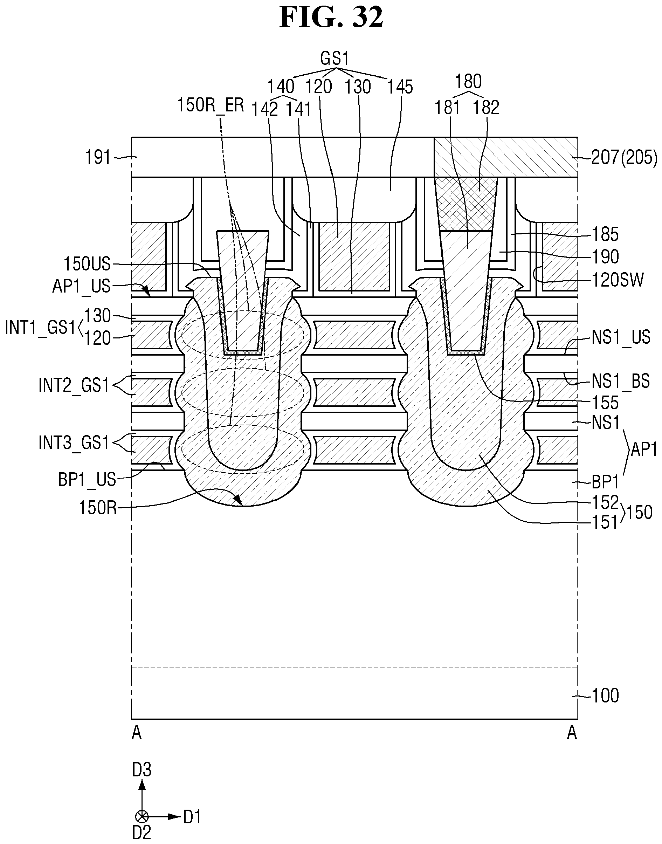

Referring to FIG. 32, in the semiconductor device according to some embodiments, the first source/drain contact 180 includes a lower source/drain contact 181 and an upper source/drain contact 182.

The upper source/drain contact 182 may be disposed at the portion that is connected to the wiring structure 205. On the other hand, the upper source/drain contact 182 may not be disposed at the portion that is not connected to the wiring structure 205.

The wiring line 207 may be connected to the first source/drain contact 180 without the wiring via 206 (see FIG. 31), in which case the wiring structure 205 does not include the wiring via 206.

Although it is illustrated that each of the lower source/drain contact 181 and the upper source/drain contact 182 is a single layer, this is merely for simplicity of description, and the present invention is not limited thereto. Each of the lower source/drain contact 181 and the upper source/drain contact 182 may include, for example, at least one of a metal, a metal alloy, a conductive metal nitride, a conductive metal carbide, a conductive metal oxide, a conductive metal carbonitride, or one or more two-dimensional (2D) material layers.

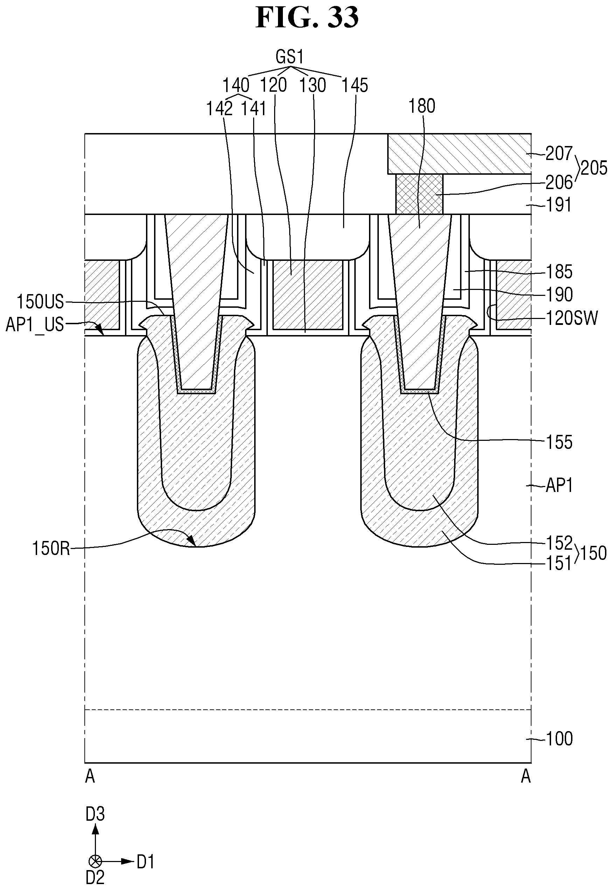

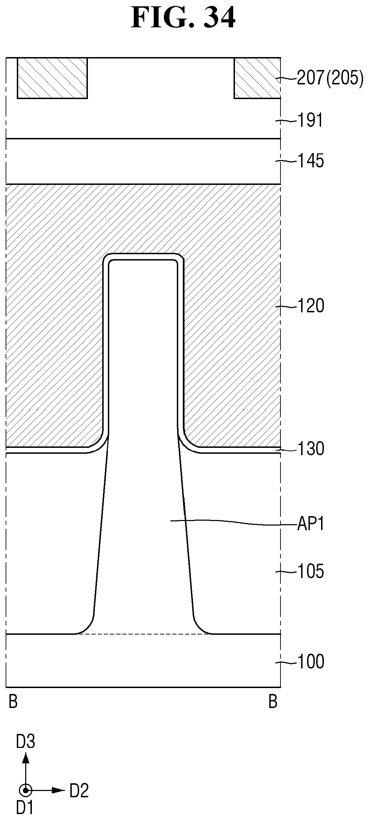

FIGS. 33 and 34 are diagrams illustrating a semiconductor device according to some embodiments. For simplicity of description, the following description will focus on differences from the description with reference to FIGS. 1 to 11.

Referring to FIGS. 33 and 34, in the semiconductor device according to some embodiments, the first active pattern AP1 may be a fin-type pattern protruding beyond the upper surface of the field insulating layer 105.

The first gate structure GS1 does not include the inner gate structures INT1_GS1, INT2_GS1, and INT3_GS1 (see FIG. 2).

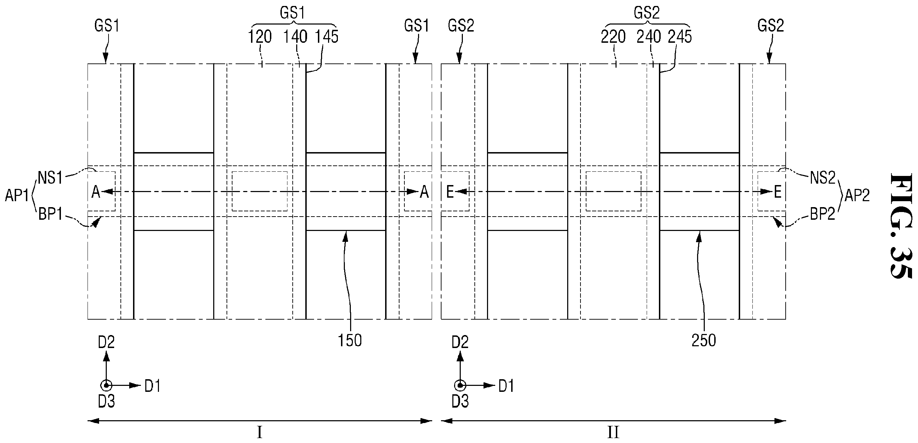

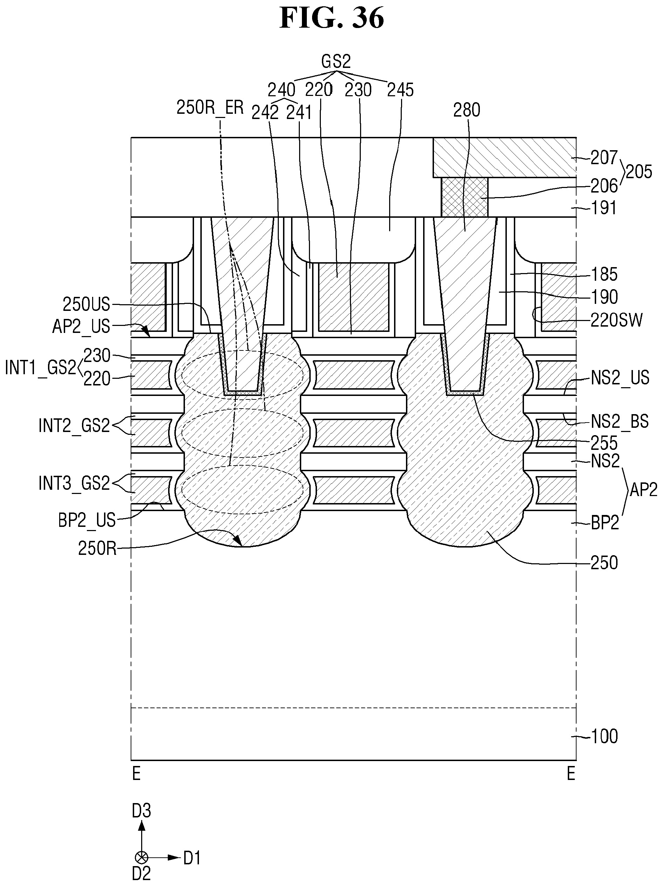

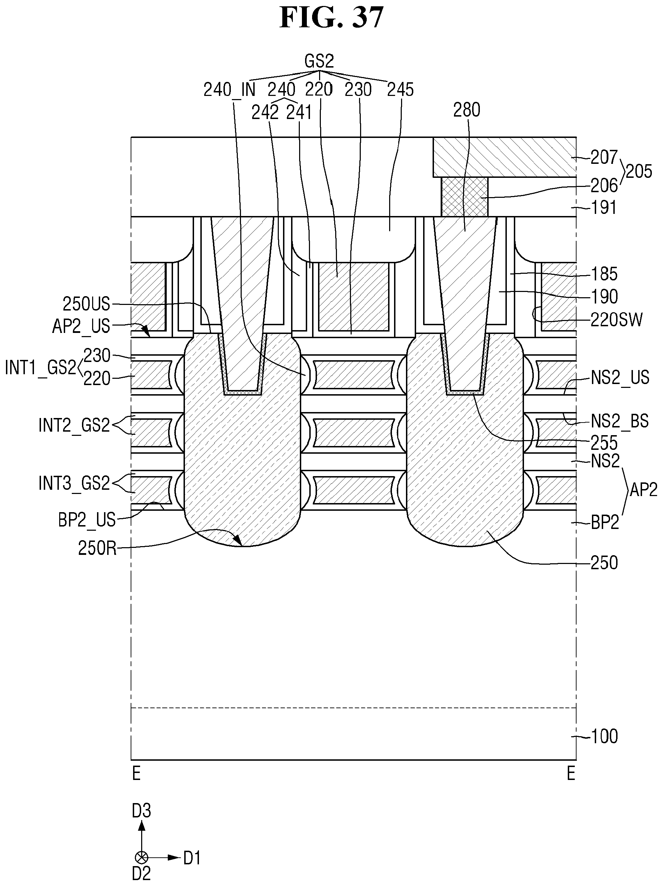

FIGS. 35 to 37 are diagrams illustrating a semiconductor device according to some embodiments. For reference, FIG. 35 is an example plan view illustrating a semiconductor device according to some embodiments. FIGS. 36 and 37 are cross-sectional views taken along line E-E of FIG. 35.

Further, the cross-sectional view taken along line A-A of FIG. 35 may be the same as one of FIGS. 2, 21, and 24 to 27. In addition, the description of a first region I of FIG. 35 may be substantially the same as the description made with reference to FIGS. 1 to 29. Therefore, the following description will focus on a second region II of FIG. 35.

Referring to FIGS. 35 to 37, the semiconductor device according to some embodiments may include the first active pattern AP1, the plurality of first gate structures GS1, the first source/drain pattern 150, a second active pattern AP2, a plurality of second gate structures GS2, and a second source/drain pattern 250.

The substrate 100 may include a first region I and a second region II. The first region I may be a region where a PMOS is formed, and the second region II may be a region where an NMOS is formed.

The first active pattern AP1, the plurality of first gate structures GS1, and the first source/drain pattern 150 are disposed in the first region I of the substrate 100. The second active pattern AP2, the plurality of second gate structures GS2, and the second source/drain pattern 250 are disposed in the second region II of the substrate 100.

The second active pattern AP2 may include a second lower pattern BP2 and a plurality of second sheet patterns NS2. The plurality of second sheet patterns NS2 are disposed on the upper surface BP2_US of the second lower pattern. The second sheet pattern NS2 includes an upper surface NS2_US and a bottom surface NS2_BS facing each other in the third direction D3. The upper surface AP2_US of the second active pattern may be the upper surface of the uppermost second sheet pattern among the plurality of second sheet patterns NS2. Each of the second lower pattern BP2 and the second sheet pattern NS2 may be formed of any one of silicon or germanium as an elemental semiconductor material, a group IV-IV compound semiconductor, and a group III-V compound semiconductor. In the semiconductor device according to some embodiments, the second lower pattern BP2 may be a silicon lower pattern containing silicon, and the second sheet pattern NS2 may be a silicon sheet pattern containing silicon.

The plurality of second gate structures GS2 may be disposed on the substrate 100. The second gate structure GS2 may be disposed on the second active pattern AP2. The second gate structure GS2 may cross the second active pattern AP2. The second gate structure GS2 may cross the second lower pattern BP2. The second gate structure GS2 may surround the second sheet patterns NS2. The second gate structure GS2 may include the plurality of inner gate structures INT1_GS2, INT2_GS2, and INT3_GS2 disposed between the second sheet patterns NS2 adjacent in the third direction D3, and between the second lower pattern BP2 and the second sheet pattern NS2. The second gate structure GS2 may include, for example, a second gate electrode 220, a second gate insulating layer 230, a second gate spacer 240, and a second gate capping pattern 345.

The second gate spacer 240 may be disposed on the sidewall 220SW of the second gate electrode. The second gate spacer 240 may include a third spacer layer 241 and a fourth spacer layer 242. The fourth spacer layer 242 may be disposed on the third spacer layer 241. The third spacer layer 241 may be disposed between the second gate electrode 220 and the fourth spacer layer 242.

In cross-sectional view of FIG. 35, the third spacer layer 341 may have an L shape, for example. The fourth spacer layer 242 may extend along the sidewall 220SW of the second gate electrode. The fourth spacer layer 242 may not extend along the upper surface 250US of the second source/drain pattern.

In FIG. 36, the second gate spacer 240 is not disposed between the second source/drain pattern 250 and the plurality of inner gate structures INT1_GS2, INT2_GS2, and INT3_GS2. The second gate insulating layer 230 included in the inner gate structures INT1_GS2, INT2_GS2, and INT3_GS2 may be in contact with the second source/drain pattern 250.

In FIG. 37, the second gate structure GS2 may include an inner spacer 240_IN. The inner spacer 240_IN may be disposed between the second sheet patterns NS2 adjacent in the third direction D3, and between the second lower pattern BP2 and the second sheet pattern NS2. The inner spacer 240_IN may be in contact with the second gate insulating layer 230 included in the inner gate structures INT1_GS2, INT2_GS2, and INT3_GS2. The inner spacer 240_IN may define a part of the second source/drain recess 250R.

The second source/drain pattern 250 may be disposed on the second active pattern AP3. The second source/drain pattern 250 may be formed on the second lower pattern BP2. The second source/drain pattern 250 may be connected to the second sheet pattern NS2. The second source/drain pattern 250 may be included in a source/drain of a transistor using the second sheet pattern NS2 as a channel region.

The second source/drain pattern 250 may be disposed in the second source/drain recess 250R. The bottom surface of the second source/drain recess 250R may be defined by the second lower pattern BP2. The sidewall of the second source/drain recess 250R may be defined by the second sheet pattern NS2 and the second gate structure GS2.

The second source/drain pattern 250 may include and/or be an epitaxial pattern. The second source/drain pattern 250 may be, for example, crystalline silicon or germanium (an elemental semiconductor material). Alternatively, the second source/drain pattern 250 may be a binary compound or a ternary compound including at least two elements selected from the group consisting of carbon (C), silicon (Si), germanium (Ge) and tin (Sn), or the above-mentioned compound doped with a group IV element. For example, the second source/drain pattern 250 may be silicon, silicon-germanium, silicon carbide, or the like, but the present invention is not limited thereto.

The second source/drain pattern 250 may include impurities doped into a semiconductor material. For example, the second source/drain pattern 250 may include n-type impurities. The doped impurities may include at least one of phosphorus (P), arsenic (As), antimony (Sb), or bismuth (Bi).

In FIG. 36, the second source/drain recess 250R may include the plurality of width extension regions 250R_ER.

In FIG. 37, the second source/drain recess 250R does not include the plurality of width extension regions 250R_ER.

The second source/drain contact 280 is disposed on the second source/drain pattern 250. The second source/drain contact 280 is connected to the second source/drain pattern 250. A second metal silicide layer 255 may be further disposed between the second source/drain contact 280 and the second source/drain pattern 250.

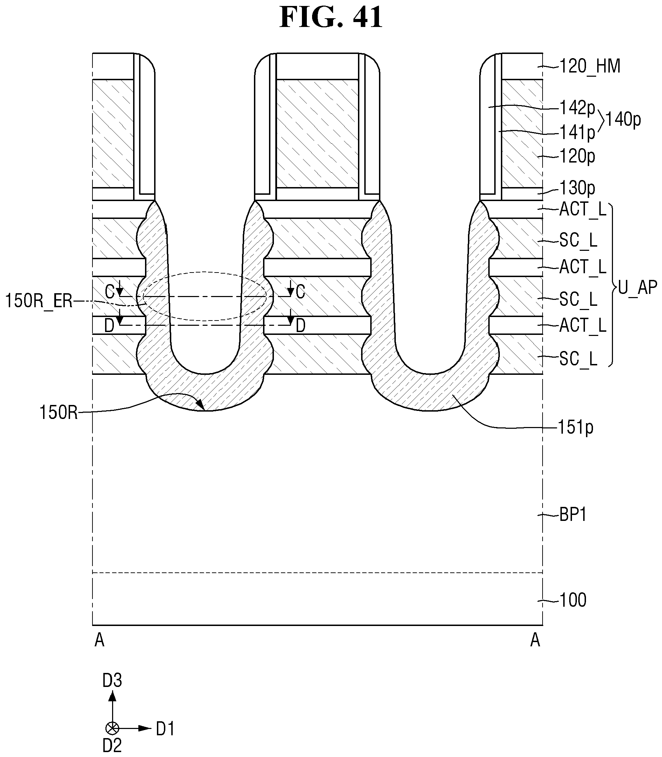

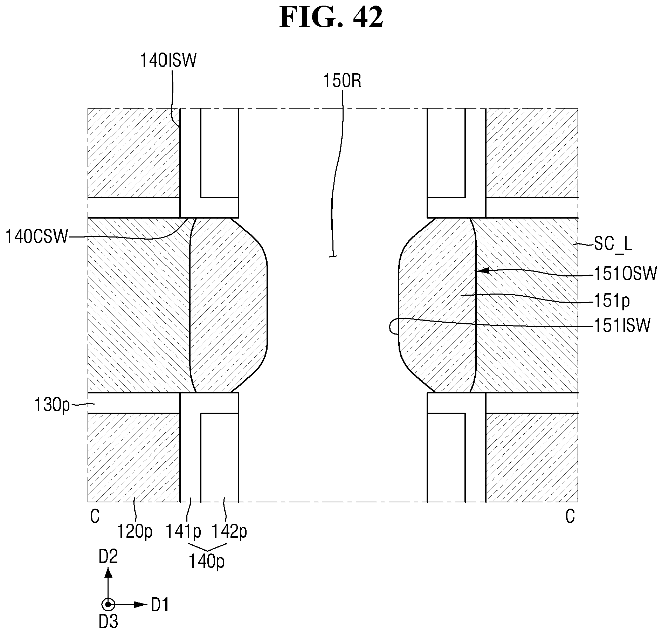

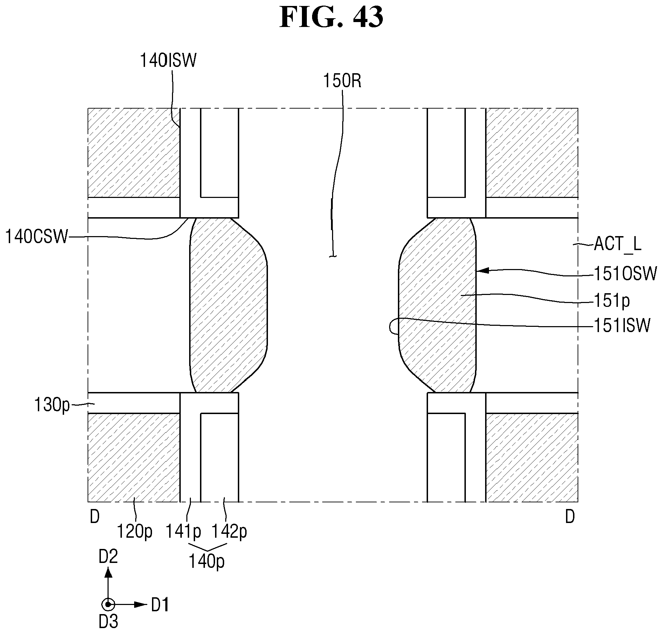

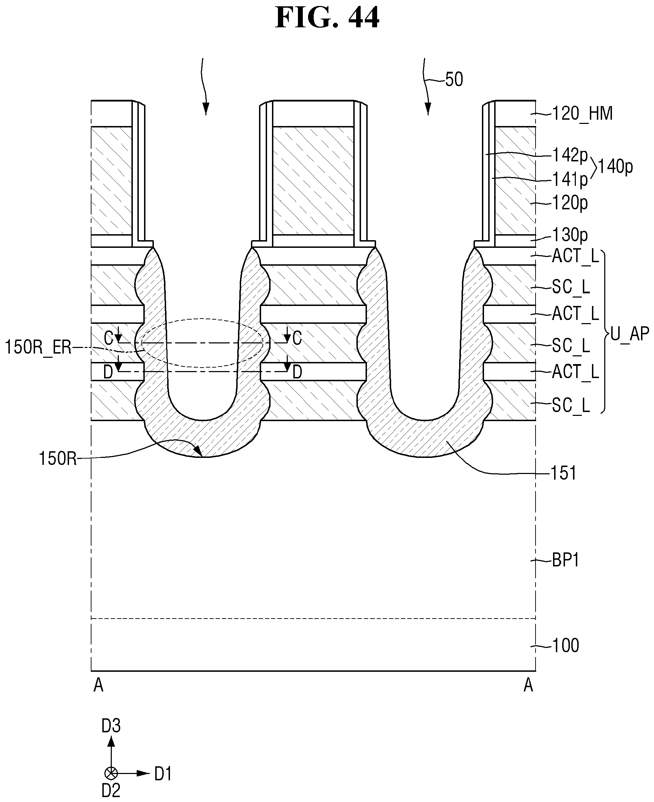

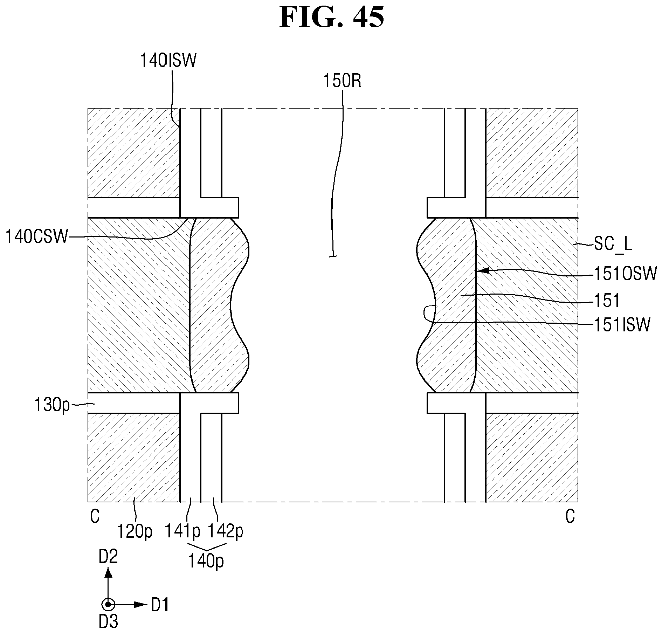

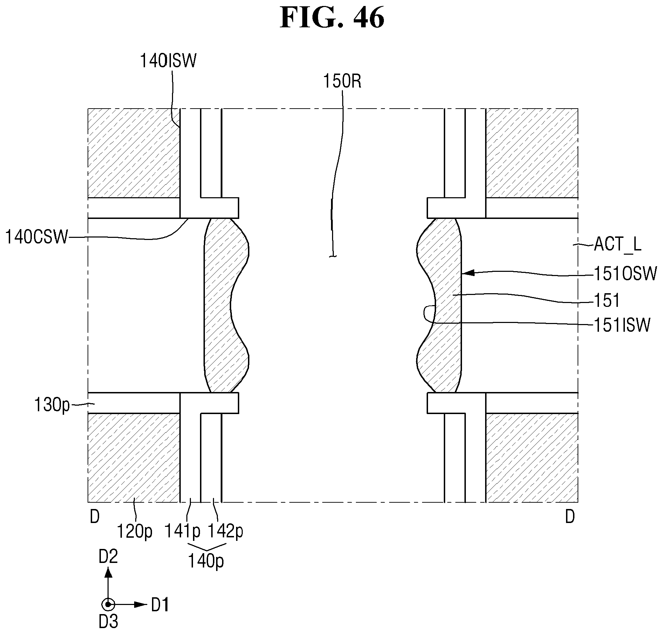

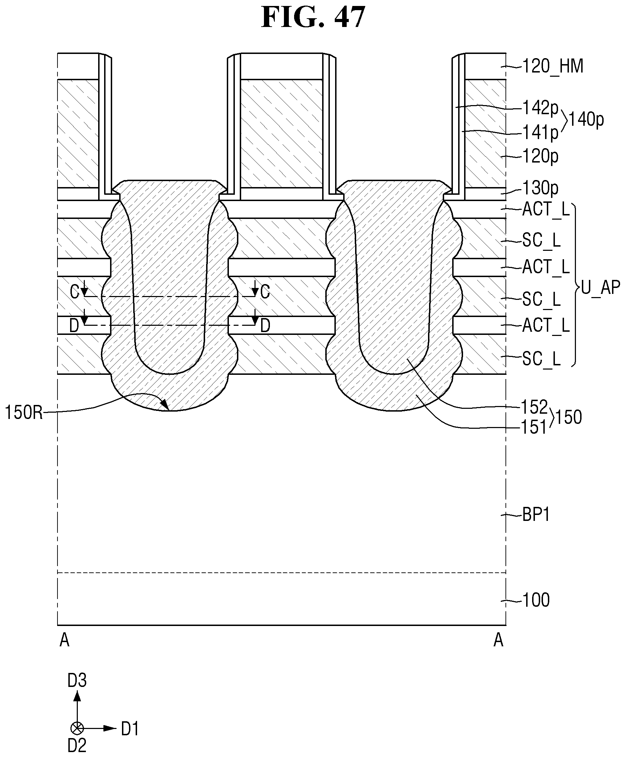

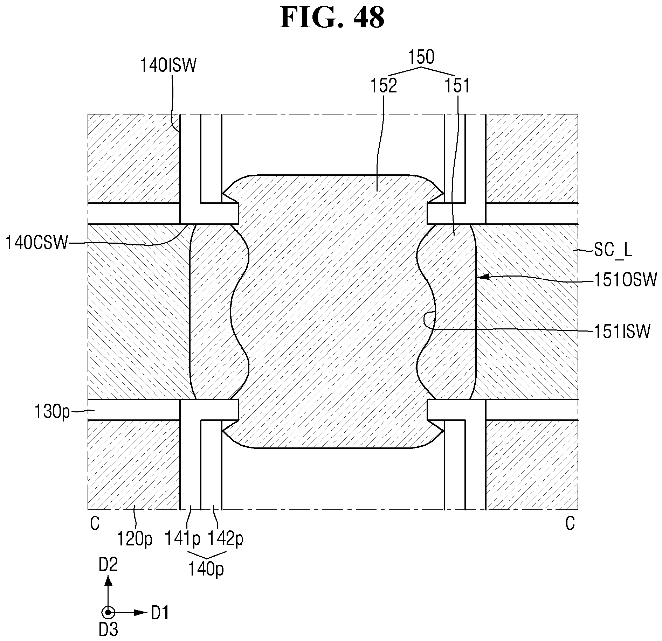

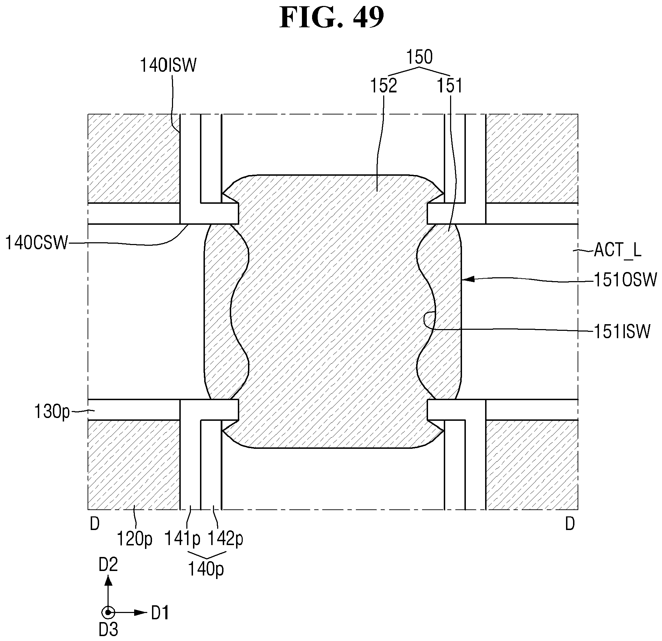

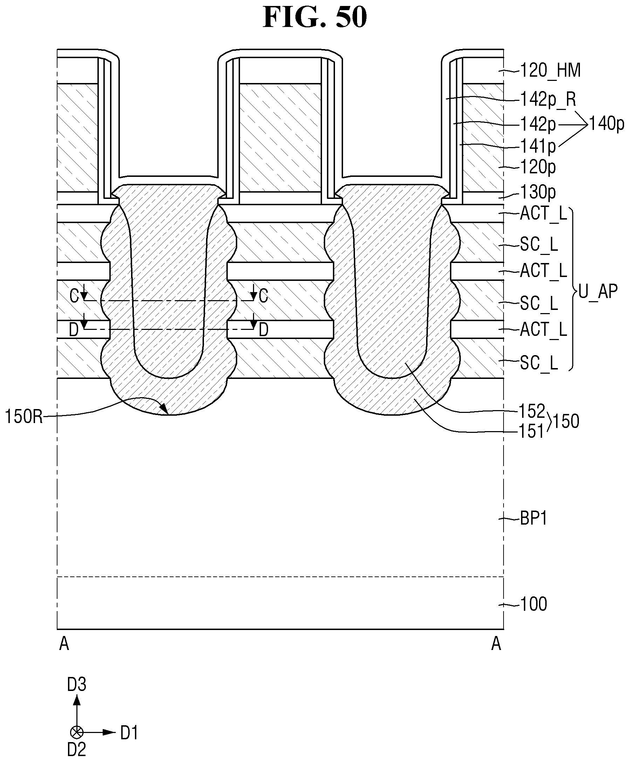

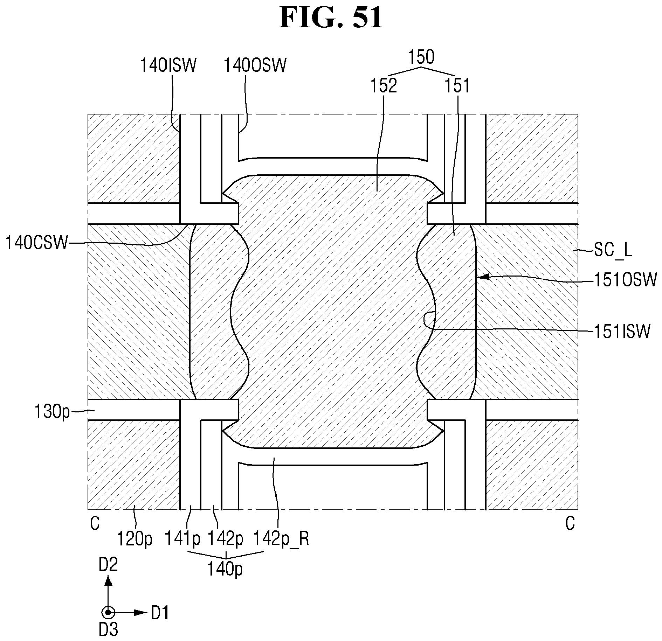

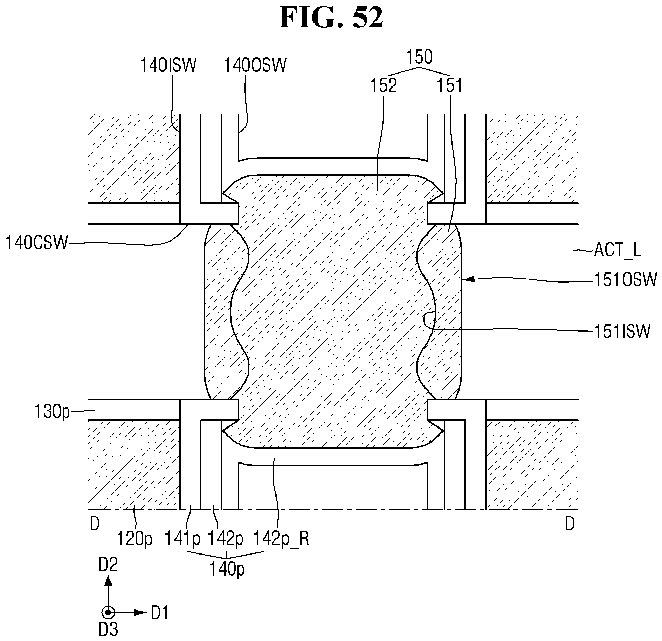

FIGS. 38 to 54 are diagrams illustrating the intermediate steps of a method for fabricating a semiconductor device according to some embodiments. FIGS. 36 to 41, 44, 47, 50, 53, and 54 may be cross-sectional views taken along line A-A of FIG. 1. FIGS. 42 and 43 are top plan views taken along lines C-C and D-D of FIG. 41. FIGS. 45 and 46 are top plan views taken along lines C-C and D-D of FIG. 44. FIGS. 48 and 49 are top plan views taken along lines C-C and D-D of FIG. 47. FIGS. 51 and 52 are top plan views taken along lines C-C and D-D of FIG. 50.

Referring to FIG. 38, the first lower pattern BP1 and an upper pattern structure U_AP may be formed on the substrate 100.

The first lower pattern BP1 extends in the first direction D1. The upper pattern structure U_AP may be disposed on the first lower pattern BP1. The upper pattern structure U_AP may include the sacrificial pattern SC_L and the active pattern ACT_L that are alternately stacked on the first lower pattern BP1. For example, the sacrificial pattern SC_L may be a silicon-germanium layer. The active pattern ACT_L may be a silicon layer. The germanium fraction of the sacrificial pattern SC_L is greater than the germanium fraction of the semiconductor liner layer 151 of FIG. 2.

Next, a dummy gate structure extending in the second direction D2 is formed on the upper pattern structure U_AP. The dummy gate structure may include a dummy gate insulating layer 130p, a dummy gate electrode 120p, and a dummy gate capping layer 120_HM. The dummy gate insulating layer 130p may be, for example, silicon oxide, but the present invention is not limited thereto. The dummy gate electrode 120p may be, for example, polysilicon, but the present invention is not limited thereto. The dummy gate capping layer 120_HM may be, for example, silicon nitride, but the present invention is not limited thereto.

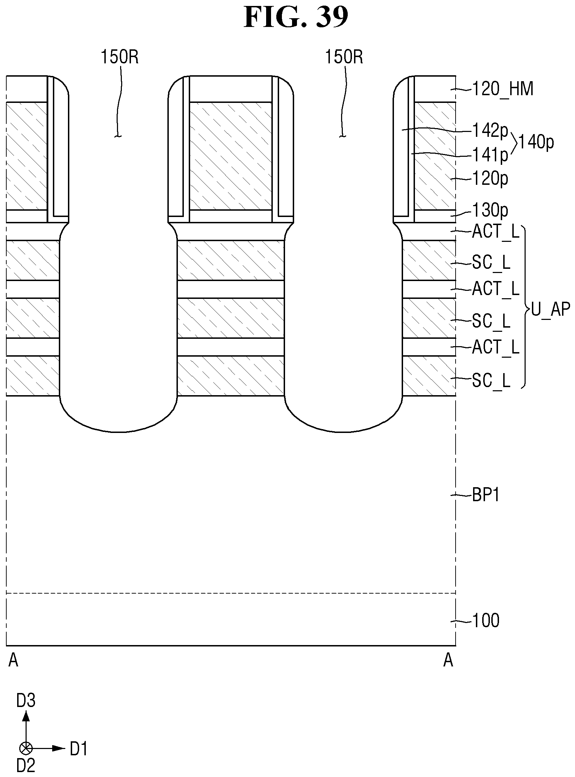

Referring to FIGS. 38 and 39, a dummy gate spacer 140p may be formed on the sidewall of the dummy gate electrode 120p.

The dummy gate spacer 140p may include a first dummy spacer layer 141p and a second dummy spacer layer 142p. The first dummy insulating layer and the second dummy insulating layer may be sequentially formed along the profile of the upper pattern structure U_AP and the profile of the dummy gate electrode 120p. Next, the first dummy insulating layer and the second dummy insulating layer may be etched by an anisotropic etching process. Accordingly, the first dummy spacer layer 141p and the second dummy spacer layer 142p may be formed.

The first dummy spacer layer 141p may include an extension portion extending along the sidewall of the dummy gate electrode 120p and a protrusion portion protruding from the extension portion of the first dummy spacer layer 141p in the first direction D1. In cross-sectional view, the second dummy spacer layer 142p may be formed on the protrusion portion of the first dummy spacer layer 141p.

The first source/drain recess 150R may be formed in the upper pattern structure U_AP while using the dummy gate spacer 140p and the dummy gate electrode 120p as masks.

A part of the first source/drain recess 150R may be formed in the first lower pattern BP1.

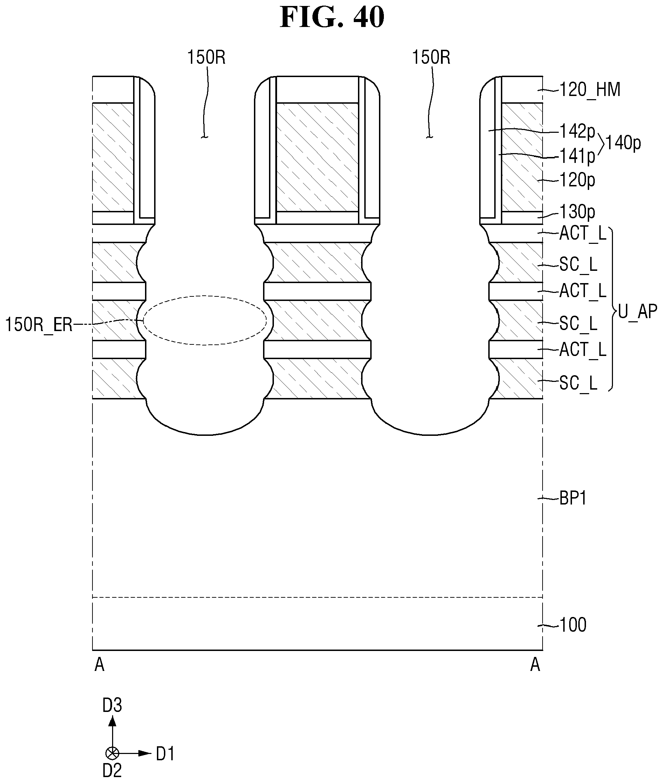

Referring to FIG. 40, a part of the sacrificial pattern SC_L exposed by the first source/drain recess 150R may be removed.

Accordingly, the width extension regions 150R_ER of the plurality of first source/drain recesses may be formed. The first source/drain recess 150R may include the width extension region 150R_ER of the first source/drain recess.

In FIGS. 39 and 40, the first source/drain recess 150R may expose at least a part of the connection sidewall 140CSW (see FIG. 42) of the dummy gate spacer 140p.

A subsequent fabricating process will be described using the shape of the first source/drain recess 150R illustrated in FIG. 40.

Referring to FIGS. 40 and 41, a pre-semiconductor liner layer 151p may be formed along the profile of the first source/drain recess 150R.

The pre-semiconductor liner layer 151p may include the outer surface 1510SW and the inner surface 151ISW. The outer wall 1510SW of the pre-semiconductor liner layer may be in contact with the sacrificial pattern SC_L and the active pattern ACT_L. The inner surface 151ISW of the pre-semiconductor liner layer may include facet surfaces and a connection surface connecting the facet surfaces. The facet surface of the inner surface 151ISW of the pre-semiconductor liner layer may extend from the connection sidewall 140CSW of the dummy gate spacer.

At least a part of the inner surface 151ISW of the pre-semiconductor liner layer 151p protrudes beyond the terminal end of the first dummy spacer layer 141p. The terminal end of the first dummy spacer layer 141p is the point located farthest from the sidewall of the dummy gate electrode 120p. Since a part of the pre-semiconductor liner layer 151p is formed to protrude beyond the terminal end of the first dummy spacer layer 141p in the first direction D1, the thickness of the pre-semiconductor liner layer 151p in contact with the connection sidewall 140CSW of the dummy gate spacer increases in plan view.

Although it is illustrated that the pre-semiconductor liner layer 151p does not extend beyond the terminal end of the first dummy spacer layer 141p along the connection sidewall 140CSW of the dummy gate spacer, the present invention is not limited thereto.

Referring to FIGS. 44 to 46, a part of the pre-semiconductor liner layer 151p is removed using a trimming process 50, so that the semiconductor liner layer 151 may be formed along the profile of the first source/drain recess 150R.

The trimming process 50 may include, for example, at least one of a dry etching process or a wet etching process. Due to the trimming process 50, the inner surface 151ISW of the semiconductor liner layer may include a concave region.

Even if a part of the pre-semiconductor liner layer 151p is removed by the trimming process 50, the semiconductor liner layer 151 in contact with the connection sidewall 140CSW of the dummy gate spacer may retain thickness.

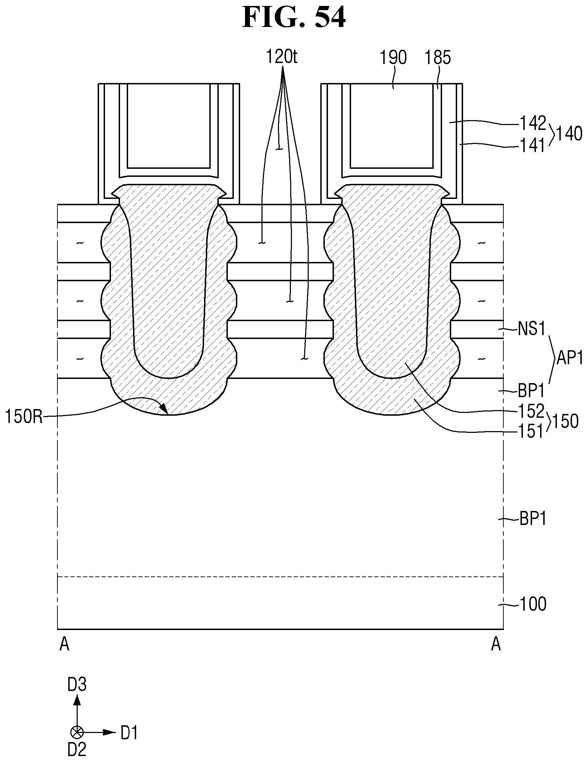

During the removal of the sacrificial pattern SC_L in FIG. 54, an etchant for removing the sacrificial pattern SC_L may permeate through the vicinity of the connection sidewall 140CSW (see FIG. 51) of the first gate spacer. The permeated etchant etches the semiconductor filling layer 152, so that the reliability and performance of the semiconductor device may deteriorate.

However, the semiconductor liner layer 151 may remain sufficiently thick at the boundary with the connection sidewall 140_CSW of the first gate so that, during the removal of the sacrificial pattern SC_L, the etchant for removing the sacrificial pattern SC_L may be prevented from permeating through the vicinity of the connection sidewall 140CSW (see FIG. 51) of the first gate spacer.

During the trimming process 50 for the pre-semiconductor liner layer 151p, at least a part of the second dummy spacer layer 142p may be removed. Unlike the drawing, the second dummy spacer layer 142p may not be removed during the trimming process 50 for the pre-semiconductor liner layer 151p.

Referring to FIGS. 47 to 49, the semiconductor filling layer 152 is formed on the semiconductor liner layer 151. Accordingly, the first source/drain pattern 150 is formed in the first source/drain recess 150R.

In cross-sectional view of FIG. 47, a part of the semiconductor filling layer 152 may overlap the protrusion portion of the first dummy spacer layer 141p in the third direction D3. In plan view of FIGS. 48 and 49, a part of the semiconductor filling layer 152 may overlap the protrusion portion of the first dummy spacer layer 141p in the second direction D2.

Referring to FIGS. 50 to 52, a third dummy spacer layer 142p_R may be formed on the first source/drain pattern 150.

The third dummy spacer layer 142p_R may be formed along the sidewall of the dummy gate electrode 120p and the upper surface of the dummy gate capping layer 120_HM. The third dummy spacer layer 142p_R includes the same material as that of the second dummy spacer layer 142p. The dummy gate spacer 140p includes the third dummy spacer layer 142p_R. Since the third dummy spacer layer 142p_R is formed, the outer wall 140OSW of the dummy gate spacer may be defined.

Unlike the above description, if the second dummy spacer layer 142p is not removed during the trimming process 50 for the pre-semiconductor liner layer 151p, the third dummy spacer layer 142p_R may not be formed.

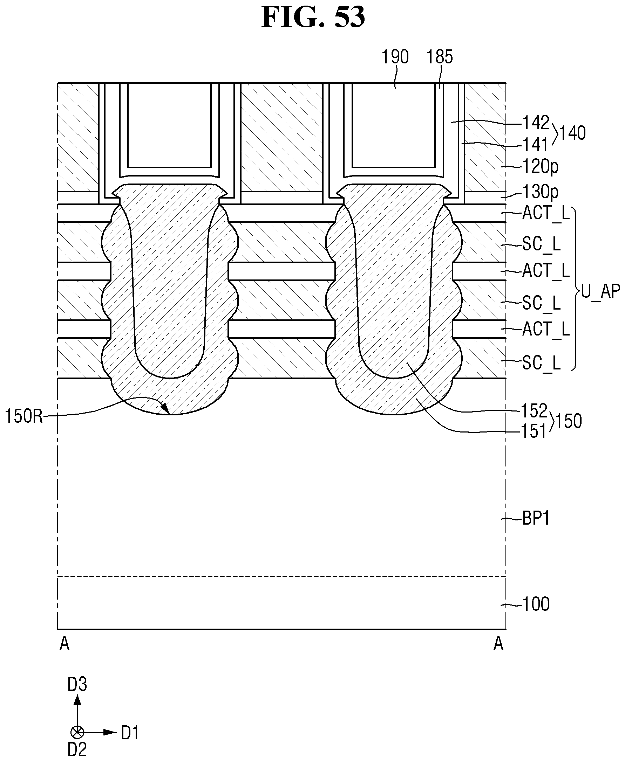

Referring to FIGS. 50 and 53, the source/drain etching stop layer 185 and the first interlayer insulating layer 190 are sequentially formed on the dummy gate spacer 140p. Next, a part of the first interlayer insulating layer 190, a part of the source/drain etching stop layer 185, and the dummy gate capping layer 120_HM are removed to expose the upper surface of the dummy gate electrode 120p.

While the upper surface of the dummy gate electrode 120p is being exposed, the first gate spacer 140 may be formed. The first dummy spacer layer 141p may become the first spacer layer 141. The second dummy spacer layer 142p and the third dummy spacer layer 142p_R may become the second spacer layer 142.

Referring to FIGS. 53 and 54, the upper pattern structure U_AP between the first gate spacers 140 may be exposed by removing the dummy gate insulating layer 130p and the dummy gate electrode 120p.

Next, the first sheet pattern NS1 may be formed by removing the sacrificial pattern SC_L. Accordingly, a first gate trench 120t is formed between the first gate spacers 140. Further, the first active pattern AP1 including the first lower pattern BP1 and the first sheet pattern NS1 is formed.

Next, referring to FIG. 2, the first gate insulating layer 130 and the first gate electrode 120 may be formed in the first gate trench 120t. Further, the first gate capping pattern 145 may be formed.

In concluding the detailed description, those skilled in the art will appreciate that many variations and modifications may be made to the preferred embodiments without substantially departing from the principles of the present inventive concept. Therefore, the disclosed preferred embodiments of the invention are used in a generic and descriptive sense only and not for purposes of limitation.

## Claims

1. A semiconductor device comprising:
an active pattern extending in a first direction;
a plurality of gate structures spaced apart from each other in the first direction on the active pattern, each gate structure comprising a gate electrode extending in a second direction and a gate spacer on a sidewall of the gate electrode; and
a source/drain pattern disposed between adjacent gate structures and comprising a semiconductor liner layer and a semiconductor filling layer on the semiconductor liner layer,
wherein the semiconductor liner layer and the semiconductor filling layer are each formed of the same compound semiconductor material,
wherein the semiconductor filling layer comprises an upper portion protruding in a third direction beyond an upper surface of the active pattern,
wherein a maximum width of the upper portion of the semiconductor filling layer in the first direction is greater than a width of the semiconductor filling layer in the first direction on the upper surface of the active pattern,
wherein the semiconductor liner layer comprises an outer surface in contact with the active pattern and an inner surface facing the semiconductor filling layer, and
in plan view, the inner surface of the semiconductor liner layer comprises a concave region.

2. The semiconductor device of claim 1, wherein the gate spacer comprises a first spacer and a second spacer,
the first spacer is disposed between the gate electrode and the second spacer,
the first spacer comprises an extension portion extending in the second direction along the sidewall of the gate electrode and a protrusion portion protruding from the extension portion of the first spacer in the first direction, and
the upper portion of the semiconductor filling layer overlaps the protrusion portion of the first spacer in the third direction.

3. The semiconductor device of claim 2, wherein a part of the second spacer extends along an upper surface of the source/drain pattern.

4. The semiconductor device of claim 2, further comprising a source/drain etching stop layer disposed on the source/drain pattern and extending along a sidewall of the gate spacer,
wherein the source/drain etching stop layer is in contact with the second spacer.

5. The semiconductor device of claim 2, wherein, in plan view, a part of the semiconductor liner layer protrudes beyond the first spacer in the first direction toward the semiconductor filling layer.

6. The semiconductor device of claim 1, wherein
the gate spacer comprises an inner wall facing the gate electrode and extending in the second direction, and a connection sidewall connected to the inner wall of the gate spacer and extending in the first direction,
the semiconductor liner layer is in contact with the connection sidewall of the gate spacer,
in plan view, an inner surface of the semiconductor liner layer comprises a first point in contact with the connection sidewall of the gate spacer, a center point, and a second point between the first point and the center point,
the second point is spaced apart from the inner wall of the gate spacer by a first distance in the first direction,
the first point is spaced apart from the inner wall of the gate spacer in the first direction by a second distance different from the first distance, and
the center point is spaced apart from the inner wall of the gate spacer in the first direction by a third distance different from the first distance.

7. The semiconductor device of claim 6, wherein the first distance is greater than the second distance and the third distance.

8. The semiconductor device of claim 6, wherein the first distance is smaller than the second distance and the third distance.

9. The semiconductor device of claim 6, wherein the first distance is smaller than the second distance and greater than the third distance.

10. The semiconductor device of claim 1, wherein
the source/drain pattern further comprises a semiconductor insertion layer disposed between the semiconductor liner layer and the semiconductor filling layer, and
the semiconductor liner layer, the semiconductor filling layer and the semiconductor insertion layer are each formed of silicon-germanium.

11. The semiconductor device of claim 1, wherein
the source/drain pattern further comprises a semiconductor capping layer disposed on the semiconductor filling layer,
the semiconductor capping layer is in contact with the semiconductor filling layer and is not in contact with the semiconductor liner layer,
the semiconductor liner layer, the semiconductor filling layer and the semiconductor capping layer are each formed of silicon-germanium, and
a germanium fraction of the semiconductor capping layer is smaller than a germanium fraction of the semiconductor filling layer.

12. The semiconductor device of claim 1, wherein
the active pattern comprises a lower pattern extending in the first direction and a plurality of sheet patterns spaced apart from the lower pattern in the third direction, and
the semiconductor liner layer is in contact with the lower pattern and the plurality of sheet patterns.

13. A semiconductor device comprising:
an active pattern extending in a first direction;
a plurality of gate structures spaced apart from each other in the first direction on the active pattern, each gate structure comprising a gate electrode extending in a second direction and a gate spacer on a sidewall of the gate electrode; and
a source/drain pattern disposed between the gate structures adjacent to each other, and comprising a semiconductor liner layer and a semiconductor filling layer on the semiconductor liner layer, wherein the semiconductor liner layer and the semiconductor filling layer are formed of a compound semiconductor material,
wherein the gate spacer comprises an extension portion extending in the second direction along a sidewall of the gate electrode, and a protrusion portion protruding from the extension portion of the gate spacer in the first direction,
wherein the gate spacer comprises an inner wall facing the gate electrode and extending in the second direction, and a connection sidewall connected to the inner wall of the gate spacer and extending in the first direction,
wherein the semiconductor liner layer comprises an outer surface in contact with the active pattern and an inner surface facing the semiconductor filling layer,
wherein, in plan view, an inner surface of the semiconductor liner layer comprises a first point located farthest from the inner wall of the gate spacer in the first direction,
wherein a distance between the first point and the inner wall of the gate spacer in the first direction is greater than a distance between a terminal end of the protrusion portion of the gate spacer and the inner wall of the gate spacer in the first direction, and
wherein the inner surface of the semiconductor liner layer comprises a concave region.

14. The semiconductor device of claim 13, wherein
the semiconductor filling layer comprises an upper portion protruding in a third direction beyond an upper surface of the active pattern, and
in at least a part of the upper portion of the semiconductor filling layer, a width of the semiconductor filling layer in the first direction increases as a distance from the upper surface of the active pattern increases.

15. A semiconductor device comprising:
an active pattern extending in a first direction;
a plurality of gate structures spaced apart from each other in the first direction on the active pattern, each gate structure comprising a gate electrode extending in a second direction and a gate spacer on a sidewall of the gate electrode;
a source/drain pattern disposed between adjacent gate structures and comprising a semiconductor liner layer and a semiconductor filling layer on the semiconductor liner layer; and
a source/drain etching stop layer disposed on the source/drain pattern, and extending along a sidewall of the gate spacer,
wherein the semiconductor liner layer and the semiconductor filling layer are formed of silicon-germanium,
wherein the gate spacer comprises a first spacer and a second spacer,
wherein the second spacer is disposed between the first spacer and the source/drain etching stop layer,
wherein the second spacer extends along the sidewall of the gate electrode and an upper surface of the source/drain pattern,
wherein a thickness of the second spacer on the sidewall of the gate electrode is greater than or equal to a thickness of the second spacer on the upper surface of the source/drain pattern,
wherein the semiconductor liner layer comprises an outer surface in contact with the active pattern and an inner surface facing the semiconductor filling layer, and
wherein, in plan view, the inner surface of the semiconductor liner layer comprises a concave region.
